# EUROPEAN PATENT SPECIFICATION

(11) **EP 2 378 562 B1**
(45) Date of publication and mention of the grant of the patent: **01.10.2014**
(21) Application number: 10729190.8
(22) Date of filing: 04.01.2010
(51) Int. Cl.: H01L 31/042, H01L 31/05, H01L 27/142

(54) **THIN-FILM SOLAR CELL MODULE**
DÜNNSCHICHTSOLARZELLENMODUL
MODULE DE CELLULES SOLAIRES À COUCHE MINCE

(30) Priority: 09.01.2009 JP 2009004012
(43) Date of publication of application: 19.10.2011
(73) Proprietor: Sharp Kabushiki Kaisha, Osaka-shi, Osaka 545-8522 (JP)
(72) Inventor: NASUNO, Yoshiyuki, Osaka 545-8522 (JP); NAKANO, Takanori, Osaka, 545-8522 (JP); SHIMIZU, Akira, Osaka, 545-8522 (JP)
(74) Representative: Hoffmann, Jörg Peter
(86) International application number: PCT/JP2010/050007
(87) International publication number: WO 2010/079770

(56) References cited:
- WO-A1-2009/011174
- JP-A- 57 053 986
- JP-A- 61 263 172
- JP-A- 2001 111 085
- JP-A- 2002 076 419
- JP-A- 2002 343 998
- JP-A- 2002 343 998
- JP-A- 2002 373 997
- JP-A- 2002 373 997
- JP-A- 2006 332 453

## Description

### TECHNICAL FIELD

The present invention relates to a thin-film solar cell module.

### BACKGROUND ART

In recent years, thin-film photoelectric conversion devices formed in accordance with a plasma CVD method using gases as materials have been receiving attention. Examples of such thin-film photoelectric conversion devices include silicon-based thin-film photoelectric conversion devices made of silicon-based thin-films and thin-film photoelectric conversion devices made of CIS (CuInSe₂) compounds and CIGS (Cu(In, Ga)Se₂) compounds, and the development of these has been accelerated and the quantity of their production has been increased. These photoelectric conversion devices are greatly characterized in that semiconductor layers or metal electrode films are layered on an inexpensive substrate having a large area using a plasma CVD apparatus, a sputtering apparatus and other film forming apparatuses, and then separated and connected through laser patterning or the like so as to provide a potential that photoelectric conversion devices having high performance can be fabricated at a low cost.

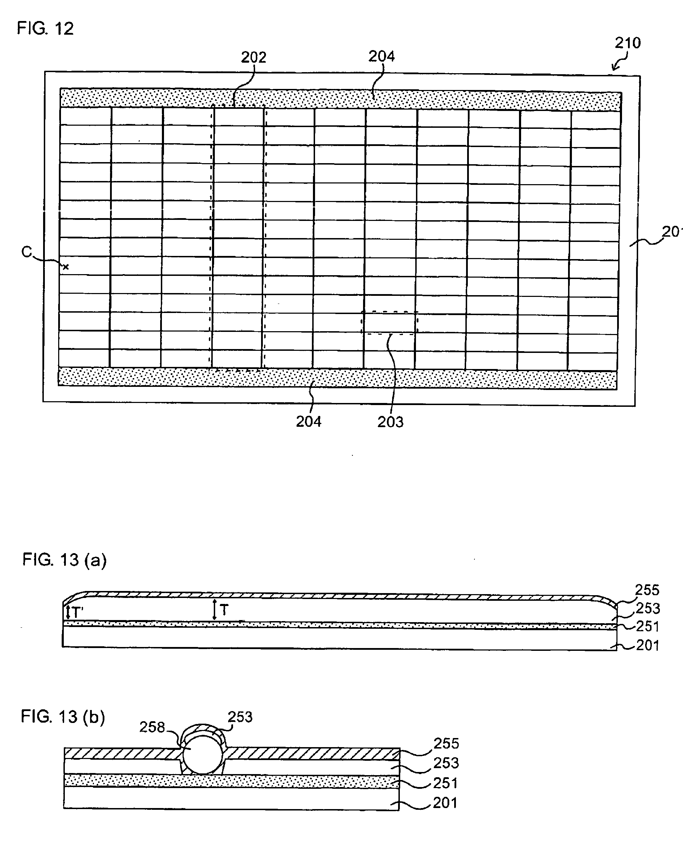

In addition, a thin-film solar cell module 210 in FIG. 12 where cell strings formed of a plurality of solar cells connected in series are connected in parallel has been known (see, for example, Patent Document 1). Here, FIG. 12 is a schematic plan diagram showing a conventional thin-film solar cell module.

JP 2002 373997 A is concerned with providing of an integrated hybrid thin-film photoelectric conversion module of high reliability. To this end it is disclosed that the integrated hybrid thin-film photoelectric conversion module comprises a multi-layer film composed of a translucent front-surface electrode layer of sheet resistor R (Omega /(square)) sequentially laminated on a glass substrate, a semiconductor film in which an amorphous photoelectric conversion unit and a crystalline photoelectric conversion unit are stacked, and a rear-surface electrode layer. The haze factor (H) is 12% or higher when the glass substrate and the translucent front-surface electrode layer are included. The multi-layer film comprises a plurality of photoelectric conversion cell arrays connected in parallel. Each cell array is partitioned into a square having a width W (mm) in the minor side direction, comprising a plurality of photoelectric conversion cells connected in series in the minor-side direction. Related to adjoining cell arrays, the semiconductor film is separated from the rear-surface electrode layer but not separated from the translucent front- surface electrode layer, satisfying an experimental formula (H+R)>=2.7× W.

JP 2002 343998 A is concerned with providing a thin-film solar cell module excellent in appearance which provides a character, symbol, pattern, etc., tinted in desired color when viewed from a surface side. To this end it is disclosed that a thin-film solar cell is provided where a transparent electrode layer, a photoelectric conversion layer, and a rear-surface electrode layer are laminated in this order on a transmission-type insulating substrate, with at least one opening formed which penetrates at least the rear-surface electrode layer and the photoelectric conversion layer among the transmission-type electrode layer, the photoelectric conversion layer, and the rear-surface electrode layer. An opaque rear-surface sealing material is bonded to the side of the thin-film solar cell opposite to a light receiving surface, and the opening part shows a desired color when viewed from the light receiving surface side. The color shown by the opening part represents the color of the rear-surface sealing material, the color of an adhesive for bonding the rear- surface sealing material to the rear-surface electrode layer, or the color of paint or a colored resist film applied on the rear-surface electrode layer and the opening part.

### PRIOR ART DOCUMENT

### PATENT DOCUMENT

Patent Document 1: Japanese Unexamined Patent Application Publication No. 2001-68713

### SUMMARY OF THE INVENTION

### PROBLEM TO BE SOLVED BY THE INVENTION

Thin-film solar cell modules have such problems that a relatively thin photoelectric conversion layer makes it easy for a leak current to flow through solar cells, and the leak current lowers the output of the thin-film solar cell module.

The present invention is provided in view of this situation and provides a thin-film solar cell module where a leak current can only slightly lower the output of the thin-film solar cell module.

### MEANS FOR SOLVING PROBLEM

The afore-mentioned problems are solved by the subject-matter of the independent claims.

The thin-film solar cell module according to the present invention has: a substrate; and a cell module having three or more cell strings, each of which has a constant width, wherein each cell string has a plurality of solar cells having the same width as the cell string and connected in series, the above-described cell strings have the same length as the above-described solar cells connected in series and are provided on the above-described substrate in parallel connection so as to be aligned in the direction perpendicular to the direction in which the above-described solar cells are connected in series, the above-described solar cells respectively have a front surface electrode, a photoelectric conversion layer and a rear surface electrode layered in this order, each cell string has contact lines having the same width as the cell string and electrically connecting the front surface electrode of a first solar cell to the rear surface electrode of a second solar cell, the first and second solar cells being included in the cell string and adjacent to each other, and the cell strings at both ends in the three or more cell strings have a width narrower than the other cell string.

The present inventors had conducted diligent research and found that the closer the cell string is to an end of the thin-film solar cell module, the easier it is for a leak current to occur in a solar cell included in the cell string. Though the reason for this is not clear, the following reason is a possibility. When the photoelectric conversion layer in a thin-film solar cell module is formed in a plasma CVD apparatus or a sputtering apparatus, for example, the closer a point is to an end of the substrate, the more difficult it is for the material for forming the photoelectric conversion layer to be supplied to the point, and therefore, in some cases, the photoelectric conversion layer 253 is thinner as it is closer to an end of the substrate 201, as shown in FIG. 13(a). Here, FIGs. 13(a) and 13(b) are schematic cross section diagrams illustrating the cause of a leak current. Thus, it is possible for a leak current to occur in a portion where the distance between the front surface electrode and the rear surface electrode is short. The following is another possibility. When a photoelectric conversion layer 253 is formed, as shown in FIG. 13(b), in some cases, particles 258 of the material get into the photoelectric conversion layer 253. When the particles 258 of the material get mixed in, the photoelectric conversion layer 253 fails to be formed in a portion, and it is possible for the material for the rear surface electrode 255 to get into this portion and cause a leak current. The closer to an end of the substrate 201 the location is, the easier it is for particles 258 of this material to get into this location. This is considered to be so because particles 258 of the material get mixed in through the inner wall of the film-forming chamber.

### EFFECTS OF THE INVENTION

In the case where a large leak current occurs in the location C in FIG. 12, for example, the output of the cell string 202 that includes the location C lowers (in many cases, the output of other cell strings is not greatly affected). In the thin-film solar cell module 210 in FIG. 12, the cell strings 202 have the same width, and therefore the output of the cell string where the leak current occurs lowers and the output of the thin-film solar cell module 210 greatly lowers.

In the thin-film solar cell module according to the present invention, the width of the cell string close to an end of the thin-film solar cell module where it is easy for a leak current to occur is smaller than the width of the other cell strings. The width of the cell strings at both ends is in a certain range. Therefore, the area of the light receiving surface of the cell strings at ends where it is easy for a leak current to occur can be smaller than the area of the light receiving surface of other cell strings. The output of the cell strings is proportional to the area of its light receiving surface, and therefore, in the thin-film solar cell module according to the present invention, the output of the cell strings at the ends where it is easy for a leak current to occur can be smaller than that of the other cell strings. Accordingly, in the thin-film solar cell module according to the present invention, in the case where a large leak current occurs in a cell string close to an end of the thin-film solar cell module, though the output of the cell string at the end of which the output is smaller than the other cell strings may lower, the output of the other larger output cell strings does not lower, and therefore the reduction in the output of the thin-film solar cell module can be small due to the effects of the leak current.

In addition, the thin-film solar cell module according to the present invention has a substrate; and a cell module having three or more cell strings, each of which has a constant width, wherein each cell string has a plurality of solar cells having the same width as the cell string and connected in series, the above-described cell strings have the same length as the above-described solar cells connected in series and are provided on the above-described substrate in parallel connection so as to be aligned in the direction perpendicular to the direction in which the above-described solar cells are connected in series, the above-described solar cells respectively have a front surface electrode, a photoelectric conversion layer and a rear surface electrode layered in this order, each cell string has contact lines having the same width as the cell string and electrically connecting the front surface electrode of a first solar cell to the rear surface electrode of a second solar cells, the first and second solar cells being included in the cell string and adjacent to each other, and the cell strings at both ends in the three or more cell strings have a width of 5 mm or more and 255 mm or less, or a width of 0.36% or more and 18% or less of the sum of the widths of all the cell strings included in the above-described cell module.

In the thin-film solar cell module according to the present invention, cell strings can be formed in portions where it is easy for a leak current to occur, and therefore the output in the portions where it is difficult for a leak current to occur can be prevented from lowering. As a result, the reduction in the output of the thin-film solar cell module can be small due to the effects of the leak current.

In addition, the thin-film solar cell module according to the present invention has: a substrate; and a cell module having three or more cell strings, each of which has a constant width, wherein each cell string has a plurality of solar cells having the same width as the cell string and connected in series, the above-described cell strings have the same length as the above-described solar cells connected in series and are provided on the above-described substrate in parallel connection so as to be aligned in the direction perpendicular to the direction in which the above-described solar cells are connected in series, the above-described solar cells respectively have a front surface electrode, a photoelectric conversion layer and a rear surface electrode layered in this order, each cell string has contact lines having the same width as the cell string and electrically connecting the front surface electrode of a first solar cell to the rear surface electrode of a second solar cell, the first and second solar cells being included in the cell string and adjacent to each other, and the cell string at the center in the three or more cell strings has a width greater than that of the other cell strings.

In the thin-film solar cell module according to the present invention, the cell string at the center where it is difficult for a leak current to occur can have a width greater than that of the other cell strings. In this area, it is particularly difficult for a leak current to occur, and therefore a cell string having a large output can be fabricated. When the width of the cell string at the center is great, the number of division lines for electrical separation can be reduced, and therefore the loss in the light receiving area and the number of steps can be reduced.

### BRIEF DESCRIPTION OF THE DRAWINGS

FIG. 1 is a schematic plan diagram showing the structure of the thin-film solar cell module according to one embodiment of the present invention;
FIG. 2(a) is a schematic cross sectional diagram along chain line S-T in FIG. 1;
FIG. 2(b) is a schematic cross sectional diagram showing an enlargement of the portion B surrounded by a dotted line in FIG. 2(a);
FIG. 3(a) is a schematic plan diagram showing the portion A surrounded by a dotted line in FIG. 1;
FIG. 3(b) is a diagram showing the cross sectional area of a contact line;
FIGs. 4(a) to 4(c) are diagrams for illustrating a term "connection in parallel in a bidirectional manner;"
FIG. 5 is a schematic plan diagram showing the thin-film solar cell module according to one embodiment of the present invention;
FIG. 6 is a schematic plan diagram showing the thin-film solar cell module according to another embodiment of the present invention;
FIG. 7 is a schematic plan diagram showing the thin-film solar cell module according to still another embodiment of the present invention;
FIG. 8 is a schematic plan diagram showing the thin-film solar cell module according to yet another embodiment of the present invention;
FIG. 9 is a schematic cross sectional diagram showing the structure of a plasma CVD apparatus used for the manufacture of the thin-film solar cell module according to one embodiment of the present invention;
FIG. 10 is a graph showing the relationship between the location of the center of each cell string in the direction in which the cell strings are divided in an RB current measuring test and the number of solar cells where the RB current is 50 mA or more;
FIG. 11 is a graph showing the distribution of the film thickness of the first photoelectric conversion layer in each location in the direction in which the cell strings are divided in the RB current measuring test;
FIG. 12 is a schematic plan diagram showing a conventional thin-film solar cell module; and
FIGs. 13(a) and 13(b) are schematic cross sectional diagrams for illustrating a cause of a leak current.

### MODE FOR CARRYING OUT THE INVENTION

In the following, one embodiment of the present invention is described in reference to the drawings. The structures shown in the drawings and in the following description are illustrative, and the scope of the present invention is not limited to these structures.

### 1. Structure of Thin-Film Solar Cell Module

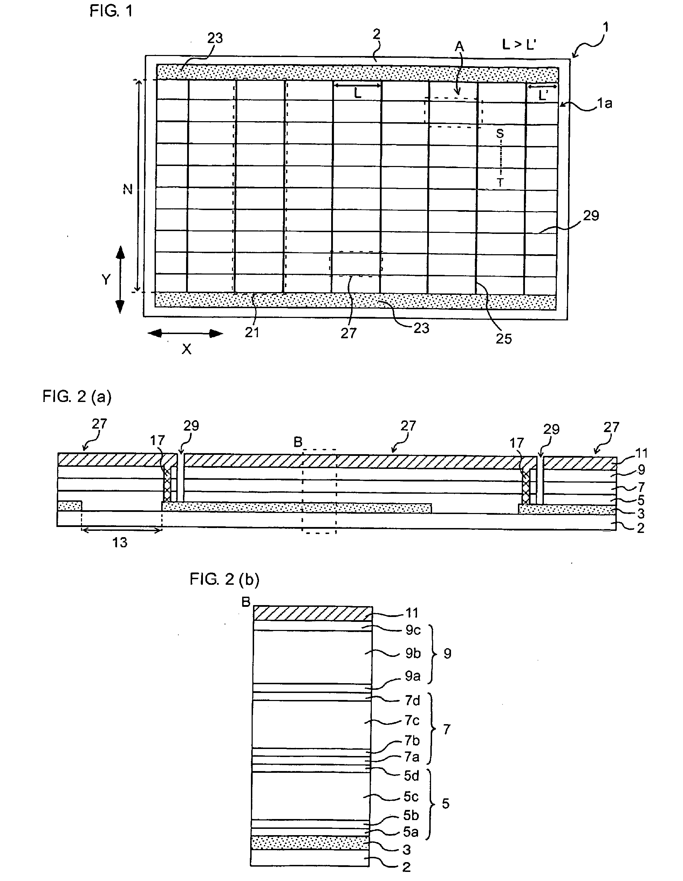

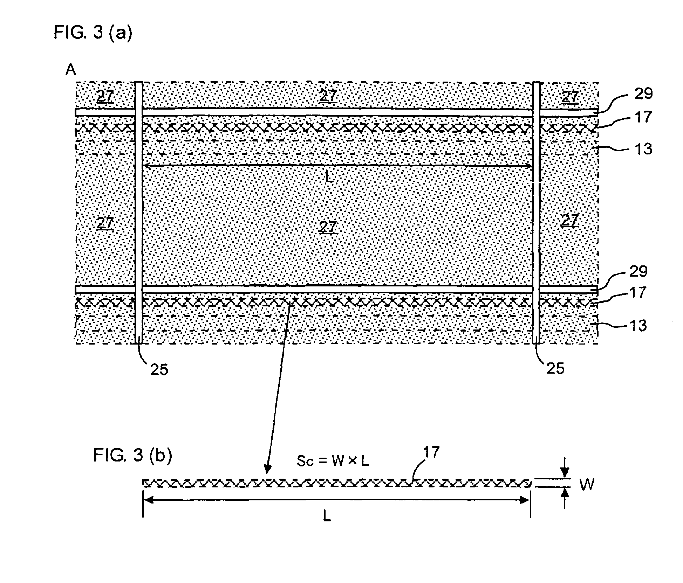

FIG. 1 is a schematic plan diagram showing the structure of the thin-film solar cell module according to one embodiment of the present invention. FIG. 2(a) is a schematic cross sectional diagram along the chain line S-T in FIG. 1, and FIG. 2(b) is a schematic cross sectional diagram showing an enlargement of the portion B surrounded by the dotted line in FIG. 2(a). In addition, FIG. 3(a) is a schematic plan diagram showing the portion A surrounded by the dotted line in FIG. 1, and FIG. 3(b) is a diagram for illustrating the cross sectional area of a contact line. Here, in FIG. 2(a), the front surface electrode dividing line 13 is wider than the contact line 17 and the rear surface electrode dividing line 29 so that the solar cells 27 can be seen as being connected in series.

Here, the thin-film solar cell modules shown in FIGs. 1 to 3 are thin-film solar cell modules having a superstrate type structure where the substrate side is a light receiving surface. However, the thin-film solar cell modules according to the present invention are not limited to those of a superstrate type structure, but may be thin-film solar cell modules having a substrate type structure where the substrate side is a rear surface. Here, in the case of a substrate type structure, a rear surface electrode, a photoelectric conversion layer and a front surface electrode are layered on a substrate in this order.

The thin-film solar cell module 1 according to the present embodiment has: a substrate 2; and a cell module 1a including three or more cell strings 21, each of which has a constant width, wherein each cell string 21 has a plurality of solar cells 27 having the same width as the cell string 21 and connected in series, the cell strings 21 have the same length as the solar cells 27 connected in series and are provided on the substrate 2 in parallel connection so as to be aligned in the direction perpendicular to the direction in which the solar cells 27 are connected in series, the solar cells 27 respectively has a front surface electrode 3, a photoelectric conversion layer (5, 7, 9) and a rear surface electrode 11 layered in this order, each cell string 21 has contact lines 17 having the same width as the cell string 27 and electrically connecting the front surface electrode 3 of a first solar cell 27 to the rear surface electrode 11 of a second solar cell 27, the first and second solar cells 27 being included in the cell string 21 and adjacent to each other, and the cell strings 27 at both ends are characterized by having a width narrower than the other cell strings 27.

In the following, each of the constitutional elements of the thin-film solar cell module 1 according to the present invention is described.

### 1-1. Substrate

The substrate 2 is not particularly limited, but in the case of a superstrate type structure, for example, substrates having light transmitting properties, such as glass substrates having a resistance to heat in the plasma CVD film forming process, and resin substrates, such as of polyimide, can be used. In the case of a substrate structure, there are no particular limitations for the substrate.

The size of the substrate 2 is not particularly limited as long as a cell module 1a can be formed.

### 1-2. Cell Module

There are no particular limitations in the cell module 1a as long as it includes three or more cell strings 21 that respectively have a constant width L and are provided on the substrate 2 as to be aligned in the direction perpendicular to the direction in which the solar cells 27 are connected in series. In addition, a plurality of cell modules 1a may be formed on the same substrate.

Here, in the present invention, the lengthwise direction is the direction in which solar cells 27 are connected in series and the crosswise direction is the direction in which the cell strings 21 are aligned. In FIG. 1, for example, the direction Y is the lengthwise direction and the direction X is the crosswise direction.

The method according to which cell strings 21 are connected in parallel is not particularly limited, but they may be connected in parallel through common electrodes 23 that are connected to both ends of each cell string 21, for example. In addition, the common electrodes 23 include first common electrodes and second common electrodes, and the first common electrodes and the second common electrodes electrically connect the cell strings so that a current generated in the cell strings can flow into each other of the cell strings. In addition, the first common electrodes and the second common electrodes can be provided so that the two electrodes of the cell strings can be electrically connected to each other.

Here, the width of the cell strings 21 in the present invention is the length of the cell strings in the crosswise direction, and the width of the cell strings 21 is the length L of the cell strings 21 in the direction in which the cell strings 21 are aligned, for example, as in FIG. 1.

Though the size of the cell module 1a is not particularly limited, the width in the direction perpendicular to the direction in which the solar cells 27 are connected in series is 500 mm or more and 3000 mm or less (a value in a range between any of the two from among 500 mm, 600 mm, 700 mm, 800 mm, 900 mm, 1000 mm, 1200 mm, 1400 mm, 1600 mm, 1800 mm, 2000 mm, 2200 mm, 2400 mm, 2600 mm, 2800 mm and 3000 mm), for example. This is because it becomes easy for a leak current to flow through the cell strings 21 at both ends when the cell module 1a is a certain size.

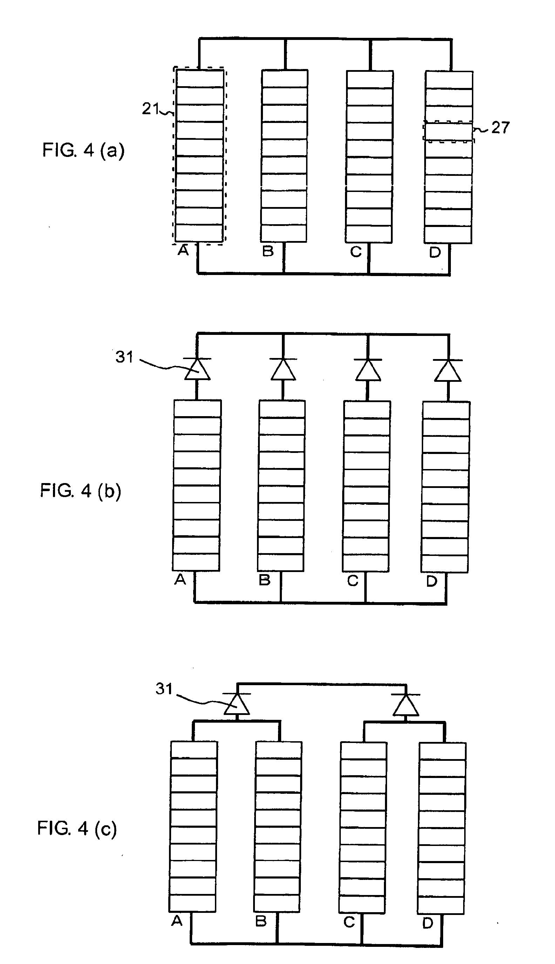

In addition, "connection in parallel in a bidirectional manner" in the present invention means such a state that a current generated in one cell string 21 can flow into the other cell string 21 and vice versa. FIGs. 4(a) to 4(c) are diagrams for illustrating the term "connection in parallel in a bidirectional manner." In the case where a plurality of cell strings 21 are connected in parallel without a blocking diode 31, as in FIG. 4(a), a current generated in the cell string A, for example, can flow into the cell string B, and a current generated in the cell string B can flow into the cell string A. Such a relationship exists between a combination of any two from among the cell strings A to D. Accordingly, the cell strings A to D are connected to each other in parallel in a bidirectional manner. Meanwhile, in the case where a plurality of cell strings 21 are connected in parallel via blocking diodes 31, as in FIG. 4(b), a current generated in the cell string A, for example, is blocked by the blocking diode 31 so as not to flow into the cell string B, and a current generated in the cell string B is blocked by the blocking diode 31 so as not to flow into the cell string A. Such a relationship exists between a combination of any two from among cell strings A to D. Accordingly, the cell strings A to D are not connected to each other in parallel in a bidirectional manner. In addition, the combination of the cell strings A and B and the combination of the cell strings C and D are respectively connected in parallel without a blocking diode 31, and these two combinations are connected in parallel via blocking diodes 31, as in FIG. 4(c). In this case, the cell strings A and B are connected to each other in parallel in a bidirectional manner and the cell strings C and D are connected to each other in parallel in a bidirectional manner. However, the cell strings A and C, for example, are not connected in parallel in a bidirectional manner.

The cell module 1a can provide an output of 90 W or more and 385 W or less under such conditions that the light source is a xenon lamp, irradiance is 100 mW/cm², AM (air mass) is 1.5, and the temperature is 25°C. As a result, this invention can be applied to a thin-film solar cell module 1 having a large photovoltaic power where a solar cell 27 or a contact line 17 is easily damaged due to a hot spot phenomenon. In many cases, reduction in the output due to a leak current becomes a problem in thin-film solar cell modules having an output in such a range.

Here, AM represents an effect of absorption and scattering of solar light in the air on the wavelength distribution of the intensity of solar light. This is AM 0 in outer space and AM 1 on the surface of the Earth in the case where the light enters vertically to the surface of the Earth. The solar light with AM at 1.5, which is one condition for the output of the solar cell, means that the light has passed through the air layer 1.5 times longer than that of AM 1.

In addition, the output of the cell module 1a can be 50 W, 60 W, 70 W, 80 W, 90 W, 100 W, 110 W, 120 W, 130 W, 140 W, 150 W, 160 W, 170 W, 180 W, 190 W, 200 W, 210 W, 220 W, 230 W, 240 W, 250 W, 260 W, 270 W, 280 W, 290 W, 300 W, 310 W, 320 W, 330 W, 340 W, 350 W, 360 W, 370 W, 380 W or 385 W, for example. The output of the cell module 1a may be any one of these numerical values or less, or may be in a range between any two.

### 1-3. Cell Strings

Each cell string 21 have a plurality of solar cells 27 having the same wide as the cell string 21 and connected in the series in the lengthwise direction, and have a constant width. In addition, each cell string 21 has two electrodes, one of which is electrically connected to a first common electrode and the other is electrically connected to a second common electrode. The two electrodes may be provided adjacent to the solar cells 27 at the ends of a plurality of solar cells 27 connected in series in the lengthwise direction. In addition, the two electrodes may be same as the front surface electrode or the rear surface electrode of the solar cells 27 at the ends. In addition, three or more cell strings 21, of which the length in the lengthwise direction is the same and each of which has a constant width, are provided on a substrate 2 so as to be aligned in the crosswise direction. The number of cell strings 21 may be 3, 4, 5, 6, 8, 10, 12, 14, 16, 18, 20, 22, 24, 26, 28 or 30, for example. In addition, the number may be in a range between any two of the numbers of cell strings 21 shown here. The number of cell strings 21 may be 3 or more and 20 or less. As a result, the light receiving area of the cell strings 21 at the ends can be sufficiently smaller than the light receiving area of the other cell strings 21, and thus the reduction in the output of the thin-film solar cell module 1 can be smaller due to a leak current.

Here, the cell strings 21 at the end in the present invention are cell strings 21 having another cell string 21 only on one side from among the cell strings 21 aligned in the crosswise direction. In FIG. 1, for example, the cell strings 21 at the ends are cell modules 21 adjacent to the two ends of the cell module 1a in the direction X from among the cell strings 21 aligned in the direction X.

The width L' of the cell strings 21 at the two ends from among the three or more cell strings 21 is smaller than the width L of the other cell strings 21. As a result, the area of the light receiving surface of the cell strings 21 at the two end is smaller than that of the other cell strings 21, and the output is also smaller than that of the other cell strings 21. As a result, even in the case where a large leak current is generated in the cell strings 21 at the two ends, reduction in the output of the thin film solar cell module 1 can be small.

In addition, the form of the cell strings 21 is not particularly limited as long as the length in the lengthwise direction is the same and the width is constant in the crosswise direction, but they are practically rectangular (or square) and are aligned in the crosswise direction.

For example, rectangular cell strings 21 can be provided and aligned in the crosswise direction, as shown in FIG. 1. In addition, in the thin-film solar cell module 1 in FIG. 1, the aligned cell strings 21 are separated from each other by alignment dividing lines 25 and are electrically connected to each other in parallel through common electrodes 23. Alignment dividing lines 25 are created so that the cell strings 21 at the two ends have a width smaller than that of the other cell strings 21.

The cell strings 21 at the two ends from among the above-described three or more cell strings 21 have a width of 5 mm or more and 255 mm or less. As a result of the below described experiment, it has been found that a leak current is easily generated in the solar cells 27 within 255 mm from an end of the cell module, and therefore when the width is 255 mm or less, the output of the cell strings inside the point 255 mm from an end where it is difficult for a leak current to be generated can be prevented from lowering. Preferably, the cell strings 21 at the two ends have a width of 5 mm or more and 155 mm or less. This is because the probability of a leak current being generated is high in this range. More preferably, the cell strings 21 at the two ends may have a width of 5 mm or more and 55 mm or less. This is because the probability of a leak current being generated is particularly high in this range.

In addition, the cell strings 21 at the two ends from among the above-described three or more cell strings 21 may have a width of 0.36% or more and 18% or less of the sum of the widths of all the cell strings 21 included in the cell module 1a. As a result, the output of the cell strings inside the point 18% of the width from an end where it is difficult for a leak current to be generated can be prevented from lowering. Preferably, the cell strings 21 at the two ends have a width 0.36% or more and 11% or less. This is because the probability of a leak current being generated is high in this range. More preferably, the cell strings 21 at the two ends have a width 0.36% or more and 4% or less. This is because the probability of a leak current being generated is particularly high in this range.

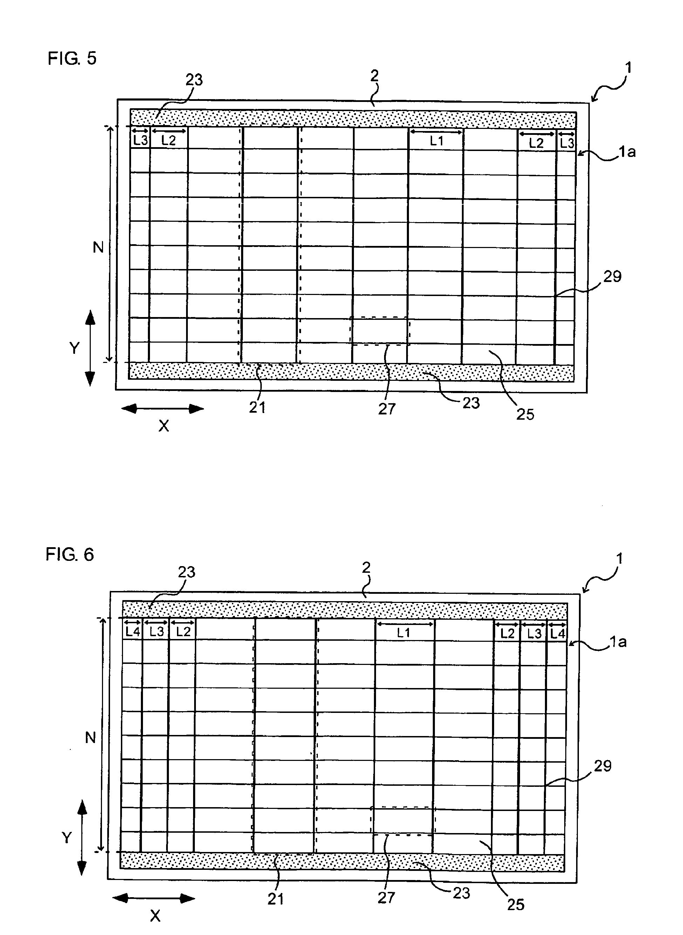

In addition, the cell module 1a includes five or more cell strings 21, and the sum of the widths of the two cell strings 21 from at least the cell string at either end from among the above-described five or more cell strings may be 11 mm or more and 255 mm or less, or 0.71% or more and 18% or less of the sum of the widths of all the cell strings 21 included in the cell module 1a. In the thin-film solar cell module 1 shown in FIG. 5, for example, the two cell strings 21 may have a width L2 and L3. The L2 + L3 may be in the above-described range. As a result, the output of the cell strings 21 where a leak current is easily generated is small so that the effect of the leak current on the output of the entire thin-film solar cell module 1 can be made small. In addition, the sum of the widths of the above-described two cell strings 21 may be 11 mm or more and 155 mm or less, or 0.71% or more and 11% or less of the sum of the widths of all the cell strings 21 included in the cell module 1a. The probability of a leak current being generated is high in this range, and therefore reduction in the output due to the effect of a leak current can be made smaller. In addition, the sum of the widths of the above-described two cell strings 21 may be 11 mm or more and 55 mm or less, or 0.71% or more and 4% or less of the sum of the widths of all the cell strings 21 included in the cell module 1a. The probability of a leak current being generated is particularly high in this range, and therefore reduction in the output due to the effect of a leak current can further be made smaller.

In addition, the cell module 1a may include seven or more cell strings 21, and the sum of the widths of the three cell strings 21 from at least either end of the above-described seven or more cell strings 21 may be 17 mm or more and 255 mm or less, or 1.07% or more and 18% or less of the sum of the widths of all the cell strings included in the cell module 1a. In the thin-film solar cell module 1 shown in FIG. 6, for example, the three cell strings 21 may have a width L2, L3 and L4. The L2 + L3 + L4 may be within the above-described range. As a result, the output of the cell strings where a leak current is easily generated can be made small, and the effects of a leak current on the output of the entire thin-film solar cell module can be made smaller. In addition, the sum of the widths of the above-described three cell strings 21 may be 17 mm or more and 155 mm or less, or 1.07% or more and 11% or less of the sum of the widths of all the cell strings 21 included in the cell module 1a. The probability of a leak current being generated is particularly high in this range, and therefore reduction in the output due to the effect of a leak current can be made smaller. In addition, the sum of the widths of the above-described three cell strings 21 may be 17 mm or more and 55 mm or less or 1.07% or more and 4% or less of the sum of the widths of all the cell strings 21 included in the cell module 1a. The probability of a leak current being generated is particularly high in this range, and therefore the effect of a leak current on the total output can further be made smaller.

In addition, the output of each cell string 21 can be made 30 W or less under such conditions that the light source is a xenon lamp, the irradiance is 100 mW/cm², AM is 1.5, and the temperature is 25°C. As a result, even in the case where one or a few solar cells 27 included in the cell string 21 are in a shade, the solar cells 27 can be prevented from being damaged due to a hot spot phenomenon (this was clarified from the below described experiment). The smaller the output of the cell string 21 is, the more the output can be prevented from lowering due to a hot spot phenomenon. When the output is small, however, the light receiving area is small and the probability of the entire cell string 21 being in a shade becomes high, thus making the probability of a contact line 17 being damaged high.

Here, the light receiving area and the output are in a proportional relationship. Here, as for a hot spot phenomenon, in the case where some solar cells included in a cell string do not receive any solar light, the photovoltaic power in the other solar cells causes insulation breakdown in the solar cells that do not receive any solar light (which work as a diode having rectification of a current in the direction opposite to that generated by the photovoltaic power), and thus heat is generated locally. This heat is considered to melt a metal included in the solar cells, and thus causes damage to the solar cell, such as film peeling.

In addition, the cell strings 21 can be connected to each other in parallel in a bidirectional manner, and the cell strings 21 at the two ends from among the aligned cell strings 21 can satisfy that (P - Ps)/Sc is 10.7 (kW/cm²) or less when the output of the above-described cell modules is P (W), the output of the cell strings is Ps (W), and the cross sectional area of the contact lines included in the cell strings is Sc (cm²) under such conditions that the light source is a xenon lamp, irradiance is 100 mW/cm², AM is 1.5, and the temperature is 25°C. As a result, even in the case where the entirety of at least one of the cell strings 21 at the two ends included in the cell module 1a is in a shade, the contact lines 17 in this cell string 21 can be prevented from being damaged (this is clarified from the below described experiment). Here, even in the case where the cell strings 21 at the two ends do not satisfy the above-described conditions, sometimes the contact lines 17 can be prevented from being damaged. Though the reason for this is not clear, the probability of a leak current flowing through the cell string 21 at an end is high, and therefore the current is not concentrated on the contact lines but is dispersed. Thus, the power consumed in the contact lines 17 is considered to be small.

Here, these contact lines 17 are considered damaged as follows. In the case where the majority of only one or a few cell strings included in the thin-film solar cell module is in a shade, the photovoltaic power of this cell string lowers. As a result, the photovoltaic power caused by the other light receiving cell strings makes a current flow through the cell string in a shade in the direction opposite to the current that flows when the cell string receives light. This current may damage a contact line for connecting solar cells in series included in the cell string. This is considered to be because the density of the power applied to the cell string in the shade due to the photovoltaic power of the light receiving cell strings becomes the greatest in the contact lines. As a result of such damage, the output of this cell string lowers, and thus the output of the thin-film solar cell module is considered to lower.

In the case where a single cell string 21 is in a shade, the power generated in all the other cell strings 21 is applied to the cell string 21 in a shade. The value of the power applied to the cell string 21 in a shade is (the power P of the cell modules 1a) - (the power Ps of the cell string 21 in a shade). The smaller the value of Ps of the cell string 21 is, the greater the value (P - Ps) is, and therefore when the output Ps of each cell string 21 is lowered by increasing the number of parallel divisions for the cell strings, the power applied to the cell string 21 in a shade increases.

In addition, the cell strings 21 other than the cell strings 21 at the two ends may have the density of the power applied to contact lines (P - Ps)/Sc be 10.7 (kW/cm²) or less when the output of said cell module 1a is P (W), the output of the cell strings 21 is Ps (W), and the area of the cross section of the contact lines 17 included in the cell strings 21 is Sc (cm²) under such conditions that the light source is a xenon lamp, the irradiance is 100 mW/cm², AM is 1.5, and the temperature is 25°C. As a result, the contact lines 17 can be prevented from being damaged even in the case where any cell string 21 in the cell module 1a is in a shade.

In addition, the cell strings 21 may have the density of the power applied to contact lines (P - Ps)/Sc be 10.7 (kW/cm²) or less when the output of said cell module 1a is P (W), the output of the cell strings 21 is Ps (W), and the area of the cross section of the contact lines 17 included in the cell strings 21 is Sc (cm²) under such conditions that the light source is a xenon lamp, the irradiance is 100 mW/cm², AM is 1.5, and the temperature is 25°C. As a result, the contact lines 17 can be prevented from being damaged even in the case where any cell string 21 in the cell module 1a is in a shade.

In addition, the cell string 21 at the center may have a width greater than that of the other cell strings 21. As a result, the output of the cell string in a portion where it is difficult for a leak current to be generated is large. In addition, when the width of the cell string at the center is great, the number of division lines for electrical division can be reduced, and therefore loss of the light receiving area and the number of steps can be reduced. Here, the cell string 21 at the center in this invention refers to one cell string at the center in the case where there is an odd number of cell strings and either of the two cell strings 21 at the center in the case where there is an even number of cell strings.

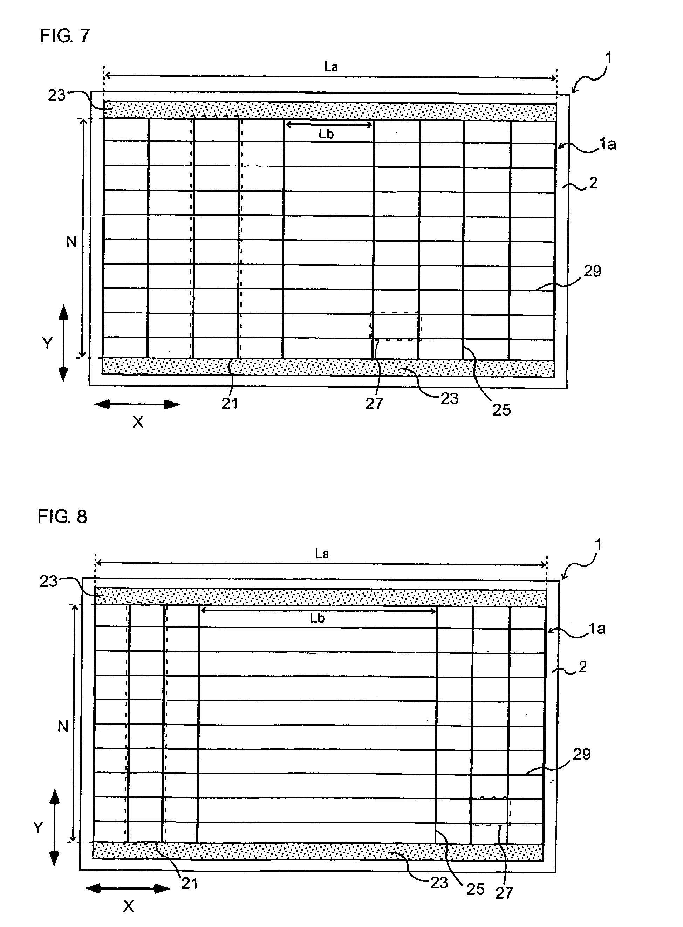

The width Lb of the cell string 21 at the center in FIG. 7, for example, is greater than the width of the other cell strings.

In addition, the cell string 21 at the center may have a width of 670 mm or less or 50% or less of the sum of the widths of all cell strings 21 included in the cell module 1a. In this range, it is particularly difficult for a leak current to flow, and therefore the effect of a leak current is small and the cell string has a large output. The width Lb of the cell string 21 at the center in FIG. 8, for example, is 50% or less of the sum of the widths La of all cell strings 21 included in the cell module 1a.

### 1-4. Solar Cells

Solar cells 27 are respectively provided with a front surface electrode 3, a photoelectric conversion layer (5, 7, 9) and a rear surface electrode 11 layered in this order. In addition, the solar cells 27 included in a cell string 21 have the same width as the cell string 21 and are connected in series in the lengthwise direction through contact lines 17, which electrically connect the front surface electrode 3 of one solar cell 27 to the rear surface electrode 11 of the adjacent solar cell 27 and have the same width as the cell string 21.

Though the form of the solar cells 27 is not particularly limited, it is practically rectangular or square. For example, a plurality of rectangular solar cells 27 can be connected in series in the direction Y, as in FIG. 1. In addition, in FIG. 1, a plurality of solar cells 27 included in the same cell string 21 are separated from each other through front surface electrode dividing lines (contact lines 17) and rear surface electrode dividing lines 29.

In the case where the thin-film solar cell module 1 is of a superstrate type, a front surface electrode 3, a photoelectric conversion layer (5, 7, 9) and a rear surface electrode 11 are provided and layered on a substrate 2 in this order. In the case where the thin-film solar cell module 1 is of a substrate type, a rear surface electrode 11, a photoelectric conversion layer (5, 7, 9) and a front surface electrode 3 are provided and layered on a substrate 2 in this order.

### 1-4-1. Front Surface Electrode

The front surface electrode 3 is made of a conductive material and has light transmitting properties. The front surface electrode 3 is made of a metal oxide, such as SnO₂, ITO or ZnO, and SnO₂, ITO or the like, which include Sn, are preferable.

### 1-4-2. Photoelectric Conversion Layer

There are no particular limitations in the photoelectric conversion layer as long as it has an n type semiconductor layer and a p type semiconductor layer so as to perform photoelectric conversion. The photoelectric conversion layer may have a pn junction made of an n type semiconductor layer and a p type semiconductor layer or a pin junction made of an n type semiconductor layer, an i type semiconductor layer and a p type semiconductor layer. In addition, the photoelectric conversion layer may have a plurality of pin junctions or pn junctions. A first photoelectric conversion layer 5, a second photoelectric conversion layer 7 and a third photoelectric conversion layer 9 may be provided, for example, as in FIG. 2. Here, the photoelectric conversion layer shown in FIG. 2 is described.

Though a case where the i type semiconductor layers in the first photoelectric conversion layer 5 and the second photoelectric conversion layer 7 are respectively amorphous layers and the i type semiconductor layer in the third photoelectric conversion layer 9 is a microcrystalline layer is cited as an example, the following descriptions can basically be applied for thin-film solar cell modules having other structures, for example, thin-film solar cell modules having such a structure that all of the i type semiconductor layers in the first to third photoelectric conversion layers are all amorphous layers or all crystal layers, thin-film solar cell modules having such a structure that the i type semiconductor layer in the first photoelectric conversion layer is an amorphous layer, and the i type semiconductor layers in the second and third photoelectric conversion layers are both microcrystalline layers, thin-film solar cell modules having such a structure as to omit either or both of photoelectric conversion the second photoelectric conversion layer and the third photoelectric conversion layer, and thin-film solar cell modules having such a structure as to be provided with another photoelectric conversion layer on the downstream side of the third photoelectric conversion layer.

In addition, though a case is cited as an example where a p type semiconductor layer, an i type semiconductor layer and an n type semiconductor layer are aligned in this order in the pin junction in each photoelectric conversion layer, the following description can basically be applied to the case where an n type semiconductor layer, an i type semiconductor layer and a p type semiconductor layer are aligned in this order in the pin junction in each photoelectric conversion layer.

The first photoelectric conversion layer 5 is provided with a p type semiconductor layer 5a, a buffer layer 5b made of an i type amorphous layer, an i type amorphous layer 5c and an n type semiconductor layer 5d layered in this order. The second photoelectric conversion layer 7 is provided with a p type semiconductor layer 7a, a buffer layer 7b made of an i type amorphous layer, an i type amorphous layer 7c and an n type semiconductor layer 7d layered in this order. The third photoelectric conversion layer 9 is provided with a p type semiconductor layer 9a, an i type microcrystalline layer 9b and an n type semiconductor layer 9c layered in this order. The buffer layers 5b and 7b can be left out. The p type semiconductor layers are doped with p type impurity atoms, such as of boron or aluminum, and the n type semiconductor layers are doped with n type impurity atoms, such as phosphorous. The i type semiconductor layers may be completely non-doped semiconductor layers or weak p type or weak n type semiconductor layers with a microscopic amount of impurities and having sufficient photoelectric conversion functions. In the present specification, semiconductor layers means amorphous or microcrystalline semiconductor layers, and amorphous layers and microcrystalline layers mean amorphous and microcrystalline semiconductor layers, respectively.

The materials of the semiconductor layers for forming the photoelectric conversion layers are not particularly limited, and examples are silicon-based semiconductors, CIS (CuInSe₂) compound semiconductors and CIGS (Cu(In, Ga)Se₂) compound semiconductors. In the following, a case where the semiconductor layers are made of silicon-based semiconductors is cited as an example. Silicon-based semiconductors means amorphous or microcrystalline silicon or semiconductors where carbon, germanium or another impurity is added to amorphous or microcrystalline silicon (silicon carbide, silicon germanium and the like). In addition, microcrystalline silicon means silicon in a mixed state of crystal silicon having a crystal grains with a small diameter (approximately several tens to several thousands of angstrom) and amorphous silicon. Microcrystalline silicon is formed in the case where a crystal silicon thin film is fabricated at a low temperature in a non-equilibrium process, such as a plasma CVD method, for example.

### 1-4-3. Rear Surface Electrode

The rear surface electrode 11 is made of a conductive material.

The structure and the material of the rear surface electrode 11 are not particularly limited, but in an example, the rear surface electrode 11 has a multilayer structure of a transparent conductive film and a metal film. The transparent conductive film is made of SnO₂, ITO, ZnO or the like. The metal film is made of a metal, such as silver or aluminum. The transparent conductive film and the metal film are formed in accordance with a method, such as CVD, sputtering or vapor deposition.

### 1-5. Contact Lines

Contact lines 17 electrically connect the front surface electrode 3 of one solar cell 27 to the rear surface electrode 11 of an adjacent solar cell that is included in the same cell string 21. As shown in FIG. 2, for example, the front surface electrodes 3 and the rear surface electrodes 11 are electrically connected. In addition, the cross section of the contact lines 17 has the same length L as the width L of the cell strings 21. As a result, when the width L of the cell strings 21 is large, the cross sectional area of the contact lines 17 is also great and wide cell strings can prevent the contact lines 17 from being damaged. As shown in FIG. 3, for example, the cross section of the contact lines 17 has the same length L as the width L of the cell strings 21. In addition, the cross sectional area Sc of the contact lines 17 in FIG. 3 can be represented by the width L of the cell strings 21 × the width W of the contact lines 17 in the lengthwise direction. In addition, in the thin-film solar cell module 1 in FIGs. 1 to 3, the contact lines 17 are formed of a conductor (for example, the same material as of the rear surface electrodes) with which photoelectric conversion layer dividing lines are filled in.

In addition, in the case where one cell string 21 included in the cell module 1a is in a shade and the photovoltaic power of the other cell strings 21 makes a current flow through the cell string 21 in a shade, the current mainly flows through the front surface electrode 3, the contact line 17 and the rear surface electrode 27 included in the cell string 21, and in many cases, the cross sectional area of the contact line 17 is the smallest from among the cross sectional areas of the conductors, and therefore the density of the power applied to the contact line 17 is the greatest.

In addition, the contact line 17 has a cross sectional area Sc of L x W, where W may be 40 µm to 200 µm and L may be 5 cm to 50 cm. As a result, the light receiving area of the solar cells 27 is secured, and in addition, the cross sectional area of the contact lines 17 is sufficiently large. The width W of one side of the cross section of the contact lines 17 is 20 µm to 300 µm, for example, and it is preferable for it to be 40 µm to 200 µm. When the width W of a side of the cross section of the contact lines 17 is small, the area Sc is small, which makes the density of the power applied to the contact lines (P - Ps)/Sc large. When the width W of a side of the cross section of the contact lines 17 is large, the effective power generating area is small. Thus, when the width W of a side of the cross section of the contact lines 17 is 40 µm to 200 µm, the density of the power applied to the contact lines (P - Ps)/Sc is not too large and a wide effective power generating area can be secured. The width W of one side of the cross section of the contact lines 17 is concretely 20 µm, 30 µm, 40 µm, 50 µm, 60 µm, 70 µm, 80 µm, 90 µm, 100 µm, 110 µm, 120 µm, 130 µm, 140 µm, 150 µm, 160 µm, 170 µm, 180 µm, 190 µm, 200 µm, 210 µm, 220 µm, 230 µm, 240 µm, 250 µm, 260 µm, 270 µm, 280 µm, 290 µm or 300 µm. The width W of one side of the cross section of the contact lines 17 may be in a range between any two of the numerical values shown here.

### 2. Plasma CVD apparatus

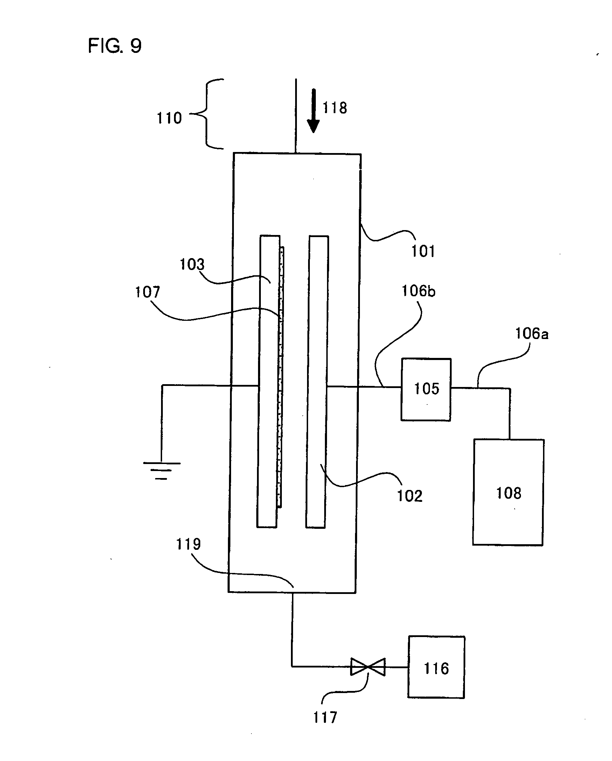

Next, a plasma CVD apparatus for forming a semiconductor layer included in the above-described thin-film solar cell module will be described by use of FIG. 9. FIG. 9 is a sectional view illustrating a structure of a plasma CVD apparatus to be used for production of the thin-film solar cell module according to the present embodiment.

The structure illustrated in FIG. 9 is an exemplification, and the semiconductor layer may be formed by use of an apparatus of another structure. In addition, the semiconductor layer may be formed by a method other than plasma CVD. Here, a plasma CVD apparatus of a single chamber type having one film forming chamber will be described as an example, but the description is also true for a plasma CVD apparatus of a multi-chamber type having a plurality of film forming chambers.

As shown in FIG. 9, the plasma CVD apparatus used in this embodiment includes: a film forming chamber 101 for forming a semiconductor layer therein, which can be hermetically sealed; a gas intake section 110 for introducing a replacement gas into the film forming chamber 101; and a gas exhaust section 116 for evacuating the replacement gas from the film forming chamber 101.

More specifically, the plasma CVD apparatus shown in FIG. 9 has a parallel plate-type electrode structure in which a cathode electrode 102 and an anode electrode 103 are installed in the film forming chamber 101 capable of being hermetically sealed. The distance between the cathode electrode 102 and the anode electrode 103 is determined depending on desired treatment conditions, and it is generally several millimeters to several tens of millimeters. A power supply section 108 for supplying electric power to the cathode electrode 102 and an impedance matching circuit 105 for matching impedances among the power supply section 108, the cathode electrode 102, and the anode electrode 103 are installed outside the film forming chamber 101.

The power supply section 108 is connected to one end of a power introducing line 106a. The other end of the power introducing line 106a is connected to the impedance matching circuit 105. One end of a power introducing line 106b is connected to the impedance matching circuit 105, and the other end of the power introducing line 106b is connected to the cathode electrode 102. The power supply section 108 may output either of a CW (continuous waveform) alternating current output or a pulse-modulated (on/off control) alternating current output, or may be one capable of switching these outputs to output.

The frequency of the alternating electric power outputted from the power supply section 108 is generally 13.56 MHz, but it is not limited thereto, and frequencies of several kHz to VHF band and a microwave band may be used.

On the other hand, the anode electrode 103 is electrically grounded, and a substrate 107 is located on the anode electrode 103. The substrate 107 is, for example, the substrate 2 on which the front surface electrode 3 is formed. The substrate 107 may be placed on the cathode electrode 102, but it is generally placed on the anode electrode 103 in order to reduce degradation of film quality due to ion damage in plasma.

The gas intake section 110 is provided in the film forming chamber 101. A gas 118 such as a dilution gas, a material gas, and a doping gas is introduced from the gas intake section 110. Examples of the dilution gas include a gas including a hydrogen gas. Examples of the material gas include a silane base gas, a methane gas, a germane gas, and the like. Examples of the doping gas include a doping gas of a p-type impurity such as a diborane gas, and a doping gas of an n-type impurity such as a phosphine gas.

Further, the gas exhaust section 116 and a pressure control valve 117 are connected in series to the film forming chamber 101, and the gas pressure in the film forming chamber 101 is kept approximately constant. It is desirable that the gas pressure is measured at a position away from the gas intake section 110 and a gas exhaust outlet 119 in the film forming chamber, because measurement of the gas pressure at a position close to the gas intake section 110 and the gas exhaust outlet 119 causes errors somewhat. By supplying electric power to the cathode electrode 102 under this condition, it is possible to generate plasma between the cathode electrode 102 and the anode electrode 103 to decompose the gas 118, and to form the semiconductor layer on the substrate 107.

The gas exhaust section 116 may be one capable of evacuating the film forming chamber 101 to reduce the gas pressure in the film forming chamber 101 to a high vacuum of approximately 1.0 x 10⁻⁴ Pa, but it may be one having an ability for evacuating gases in the film forming chamber 101 to a pressure of approximately 0.1 Pa in view of simplification of an apparatus, cost reduction, and an increase in throughput. The volume of the film forming chamber 101 has been getting larger as the size of the substrate of the semiconductor device grows. When such a film forming chamber 101 is highly evacuated to a vacuum, a high-performance gas exhaust section 116 is required, and therefore it is not desirable from the viewpoint of simplification of an apparatus and cost reduction, and it is more desirable to use a simple gas exhaust section 116 for a low vacuum.

Examples of the simple gas exhaust section 116 for a low vacuum include a rotary pump, a mechanical booster pump, a sorption pump, and the like, and it is preferable to use these pumps alone or in combination of two or more kinds thereof.

The film forming chamber 101 of the plasma CVD apparatus used in this embodiment can be sized in approximately 1 m³, for example. As a typical gas exhaust section 116, a mechanical booster pump and a rotary pump connected in series can be used.

### 3. Method for producing thin-film solar cell module

Next, a method for producing the thin-film solar cell module according to an embodiment of the present invention will be described by use of FIG. 1, FIG. 2, FIGs. 3 (a) (b), and FIG. 9.

Hereinafter, the method will be described taking, as an example, the case of forming the semiconductor layer by use of a plasma CVD apparatus of a single chamber type having one film forming chamber as shown in Fig. 9, but the following description is basically also true for the case of forming the semiconductor layer by use of a plasma CVD apparatus of a multi-chamber type. However, with the plasma CVD apparatus of a multi-chamber type, a gas replacement step to be described later can be omitted, because the p-type, the i-type, and the n-type semiconductor layers can be formed in different film forming chambers.

In the production method of this embodiment, the first photoelectric conversion layer 5, the second photoelectric conversion layer 7, and the third photoelectric conversion layer 9 are formed in the same film forming chamber. To form the photoelectric conversion layers in the same film forming chamber means that the first, second, and third photoelectric conversion layers 5, 7, 9 are formed by use of the same electrode or different electrodes in the same film forming chamber, and it is desirable that the first, second, and third photoelectric conversion layers 5, 7, 9 are formed by use of the same electrode in the same film forming chamber. Further, it is desirable from the viewpoint of improving production efficiency that the first, second, and third photoelectric conversion layers 5, 7, 9 are successively formed without being released to the air on the way. Furthermore, it is desirable from the viewpoint of improving production efficiency that substrate temperatures during the formation of the first, second, and third photoelectric conversion layers 5, 7, 9, are the same.

Hereinafter, a method for producing the thin-film solar cell module 1 will be described in detail. The method to be described below is exemplification, and the thin-film solar cell module 1 may be produced by a method other than the method to be described below.

### 3-1. Step of forming front surface electrode

First, the front surface electrode 3 is formed on the substrate 2. For example, they may be formed by a method such as a CVD method, a sputtering method, and a vapor deposition method.

### 3-2. Step of forming front surface electrode division line

Next, the front surface electrode division line 13 dividing the front surface electrode 3 is formed in a crosswise direction. For example, the front surface electrode division line 13 extending in an X direction in FIG. 1 (in a direction of a longer side of the substrate 2; in a direction in which the plurality of cell strings 21 in the cell module 1a are arranged) is formed on the front surface electrode 3, thereby dividing the front surface electrode 3 into a pattern of a plurality of band-like shapes. The front surface electrode division line 13 may be formed by, for example, scribing the front surface electrode 3 by use of a fundamental wave of a YAG laser.

### 3-3. Step of forming first photoelectric conversion layer

Next, the first photoelectric conversion layer 5 is formed on the obtained substrate. As described above, since the first photoelectric conversion layer 5 has the p-type semiconductor layer 5a, the buffer layer 5b, the i-type amorphous layer 5c, and the n-type semiconductor layer 5d, the respective semiconductor layers are formed in order.

A gas replacement step of replacing the inside of the film forming chamber 101 with a replacement gas is performed to reduce the concentration of impurities in the film forming chamber 101 before the formation of the p-type semiconductor layer 5a (that is, before the formation of the first photoelectric conversion layer 5) and before the formation of the i-type amorphous layer 5c. Since the impurities introduced in the preceding step or the impurities immixed from the outside when a substrate is carried into the film forming chamber 101 remain in the film forming chamber 101, quality of the semiconductor layer is deteriorated if the semiconductor layer takes in the impurities. Therefore, the concentration of the impurities in the film forming chamber 101 is reduced in advance. The gas replacement step is also performed before the formation of the p-type semiconductor layer 7a (that is, before the formation of the second photoelectric conversion layer 7), before the formation of the i-type amorphous layer 7c, before the formation of the p-type semiconductor layer 9a (that is, before the formation of the third photoelectric conversion layer 9), and before the formation of the i-type microcrystalline layer 9b. Here, each gas replacement step may be performed under the same condition, or under different conditions.

In addition, when the plasma CVD apparatus of a multi-chamber type is used, the concentration of the impurities in the film forming chamber can be reduced by changing the film forming chamber in place of performing the gas replacement step. In general, the p-type semiconductor layer 5a and the buffer layer 5b are formed in a first film forming chamber, the i-type amorphous layer 5c is formed in a second film forming chamber, and the n-type semiconductor layer 5d is formed in a third film forming chamber. Further, the p-type semiconductor layer 7a, the buffer layer 7b, and the p-type semiconductor layer 9a are formed in the first film forming chamber, the i-type amorphous layer 7c and the i-type microcrystalline layer 9b are formed in the second film forming chamber, and the n-type semiconductor layer 7d and the n-type semiconductor layer 9c are formed in the third film forming chamber. The p-type amorphous layer and the buffer layer may be formed in different film forming chambers.

Hereinafter, a step of forming the first photoelectric conversion layer 5 will be described in detail.

### 3-3-1. Gas replacement step

The substrate 2 on which the front surface electrode 3 is formed is installed in the film forming chamber 101, and thereafter the gas replacement step of replacing the inside of the film forming chamber 101 with a replacement gas is performed. This gas replacement step is performed to reduce the concentration of the impurities which are immixed from the outside of the film forming chamber 101 in carrying a substrate to be provided with a semiconductor layer into the film forming chamber 101. Further, when the thin-film solar cell module is produced repeatedly, the first to third photoelectric conversion layers are formed repeatedly, and therefore the n-type semiconductor layer 9c of the third photoelectric conversion layer 9, previously formed, is deposited on an inner wall, an electrode, and the like in the film forming chamber 101. Therefore, it will be a problem that impurities released from the n-type semiconductor layer 9c of the third photoelectric conversion layer 9, particularly impurities that determine a conductive type of the n-type semiconductor layer 9c of the third photoelectric conversion layer 9, are immixed in the p-type semiconductor layer 5a of the first photoelectric conversion layer 5. Accordingly, the gas replacement step is performed before the formation of the p-type semiconductor layer 5a to reduce the amount of n-type impurities to be immixed in the p-type semiconductor layer 5a.

Thereby, a semiconductor layer of good quality can be formed as the p-type semiconductor layer 5a of the first photoelectric conversion layer 5. Here, since the p-type semiconductor layer 5a generally includes p-type conductive impurities in a concentration of approximately 1 × 10²⁰ cm⁻³, satisfactory photoelectric conversion characteristics are attained if the concentration of the immixed n-type conductive impurities is approximately 1 x 10¹⁸ cm⁻³ or less, which is 2 digits less than the concentration of the p-type conductive impurities.

The gas replacement step can be performed through an operation cycle in which, for example, a hydrogen gas is introduced into the film forming chamber 101 as a replacement gas (step of introducing a replacement gas), the introduction of the hydrogen gas is stopped when the internal pressure of the film forming chamber 101 reaches a predetermined pressure (for example, approximately 100 Pa to 1000 Pa), and the hydrogen gas is evacuated until the internal pressure of the film forming chamber 101 reaches a predetermined pressure (for example, approximately 1 Pa to 10 Pa) (evacuation step). This cycle may be repeated more than once.

The period of time required to perform the above-mentioned one cycle can be several seconds to several tens of seconds. Specifically, the step of introducing a replacement gas can be performed over 1 to 5 seconds, and the evacuation step can be performed over 30 to 60 seconds. Even when the steps are performed in such a short period of time, the concentration of the impurities in the film forming chamber can be reduced by repeating this cycle more than once. Therefore, the method for producing the thin-film solar cell module according to this embodiment is also practical when it is applied to mass production devices.

In this embodiment, it is preferable that an internal pressure of the film forming chamber 101 after introducing a replacement gas and an internal pressure after evacuating the replacement gas are set in advance. In the step of introducing a replacement gas, the evacuation from the film forming chamber 101 is stopped, and when the internal pressure of the film forming chamber 101 reaches above the internal pressure after introducing the replacement gas, the introduction of the replacement gas is stopped to terminate the step of introducing a replacement gas. In the evacuation step, the introduction of the replacement gas is stopped, and when the internal pressure of the film forming chamber 101 reaches below the internal pressure after evacuating the replacement gas, the evacuation is stopped to terminate the evacuation step.

By increasing the number of repetitions of the cycle, or by decreasing the ratio (M/m) of a pressure M after evacuating the replacement gas to a pressure m after introducing the replacement gas, the concentration of the impurities existing in the film forming chamber 101 can be more reduced.

Further, in this embodiment, the present invention is described taking, as an example, the case where a hydrogen gas is used as a replacement gas, but in another embodiment, any gas usable for formation of an i-type layer, such as a silane gas, may be used as a replacement gas. The gas usable for the formation of the i-type layer are also usable for the formation of any of the p-type, i-type, and n-type semiconductor layers. Accordingly, it is preferable to use a gas used for the formation of the i-type layer as a replacement gas, because in this case, no impurity from this gas is immixed in the semiconductor layer.

Further, in another embodiment, an inert gas or the like, which does not have an effect on film quality of the semiconductor layer may be used as a replacement gas. In particular, a gas having a large atomic weight is apt to remain in the film forming chamber 101 after the evacuation of the inside of the film forming chamber 101 and is suitable for a replacement gas. Examples of the inert gas include an argon gas, a neon gas, a xenon gas, and the like.

Further, the replacement gas may be a mixture gas of any one or more of gases usable for the formation of the i-type layer and one or more inert gases.

### 3-3-2. Step of forming p-type semiconductor layer

Next, the p-type semiconductor layer 5a is formed. Hereinafter, a step of forming the p-type semiconductor layer 5a will be described.

First, the inside of the film forming chamber 101 can be evacuated to a pressure of 0.001 Pa and the substrate temperature can be set at a temperature of 200°C or lower. Thereafter, the p-type semiconductor layer 5a is formed. A mixture gas is introduced into the film forming chamber 101 and the internal pressure of the film forming chamber 101 is kept approximately constant by a pressure control valve 117 provided in an exhaust system. The internal pressure of the film forming chamber 101 is in a range of, for example, 200 Pa to 3600 Pa. As the mixture gas to be introduced into the film forming chamber 101, for example, a gas including a silane gas, a hydrogen gas, and a diborane gas can be used. Further, the mixture gas can include a gas (for example, methane gas) containing carbon atoms in order to reduce the amount of light absorption. The flow rate of the hydrogen gas can be 5 times or more and 300 times or less larger than that of the silane gas, and it is preferably approximately 5 times to 30 times in the case of forming a p-type amorphous layer, and 30 times to 300 times in the case of forming a p-type microcrystalline layer.

After the internal pressure of the film forming chamber 101 is stabilized, an alternating electric power of several kHz to 80 MHz is inputted to the cathode electrode 102 to generate plasma between the cathode electrode 102 and the anode electrode 103, thereby forming an amorphous or microcrystalline p-type semiconductor layer 5a. The power density per unit area of the cathode electrode 102 is preferably in a range of 0.01 W/cm² to 0.3 W/cm² in the case of forming a p-type amorphous layer, and it is preferably in a range of 0.02 W/cm² to 0.5 W/cm² in the case of forming a p-type microcrystalline layer.

Thus, the p-type semiconductor layer 5a having a desired thickness is formed, and then input of the alternating electric power is stopped and the film forming chamber 101 is evacuated to a vacuum.

The thickness of the p-type semiconductor layer 5a is preferably 2 nm or more, more preferably 5 nm or more in terms of providing an adequate internal electric field for the i-type amorphous layer 5c. Further, the thickness of the p-type semiconductor layer 5a is preferably 50 nm or less, more preferably 30 nm or less in terms of necessity for suppressing the amount of light absorption on a side of light entrance of an inactive layer.

### 3-3-3. Step of forming buffer layer

Next, an i-type amorphous layer is formed as the buffer layer 5b. First, a background pressure in the film forming chamber 101 is evacuated to a vacuum of approximately 0.001 Pa. The substrate temperature can be set at a temperature of 200°C or lower. Next, a mixture gas is introduced into the film forming chamber 101, and the internal pressure of the film forming chamber 101 is kept approximately constant by the pressure control valve 117. The internal pressure of the film forming chamber 101 is adjusted to be in a range of, for example, 200 Pa to 3000 Pa. As the mixture gas to be introduced into the film forming chamber 101, for example, a gas including a silane gas and a hydrogen gas can be used. Further, the mixture gas can include a gas (for example, methane gas) containing carbon atoms in order to reduce the amount of light absorption. Desirably, the flow rate of a hydrogen gas is approximately several times to several tens of times larger than that of a silane gas.

After the internal pressure of the film forming chamber 101 is stabilized, an alternating electric power of several kHz to 80 MHz is inputted to the cathode electrode 102 to generate plasma between the cathode electrode 102 and the anode electrode 103, thereby forming an i-type amorphous layer as the buffer layer 5b. The power density per unit area of the cathode electrode 102 may be in a range of 0.01 W/cm² to 0.3 W/cm².

Thus, the i-type amorphous layer having a desired thickness is formed as the buffer layer 5b, and then input of the alternating electric power is stopped and the inside of the film forming chamber 101 is evacuated to a vacuum.

By forming the i-type amorphous layer as the buffer layer 5b, the concentration of boron atoms in atmosphere in the film forming chamber 101 is reduced to allow reduction of boron atoms to be immixed in the i-type amorphous layer 5c to be formed next.

The thickness of the i-type amorphous layer as the buffer layer 5b is desirably 2 nm or more in order to inhibit diffusion of boron atoms from the p-type semiconductor layer 5a to the i-type amorphous layer 5c. On the other hand, this thickness is desirably as small as possible in order to suppress the amount of light absorption to increase light reaching the i-type amorphous layer 5c. The thickness of the buffer layer 5b is generally adjusted to 50 nm or less.

### 3-3-4. Gas replacement step

Next, a gas replacement step is performed in the same manner as in "3-3-1. Gas replacement step".

The p-type semiconductor layer 5a, formed in the preceding step, is deposited on an inner wall and an electrode in the film forming chamber 101. Therefore, it will be a problem that impurities released from the p-type semiconductor layer 5a, particularly impurities that determine a conductive type of the p-type semiconductor layer 5a are immixed in the i-type amorphous layer 5c, but by performing the gas replacement step before the formation of the i-type amorphous layer 5c, the amount of the above-mentioned impurities to be immixed in the i-type amorphous layer 5c can be reduced. Thereby, a semiconductor layer of good quality can be formed as the i-type amorphous layer 5c.

### 3-3-5. Step of forming i-type amorphous layer

Next, the i-type amorphous layer 5c is formed. First, the background pressure in the film forming chamber 101 is evacuated to a vacuum of approximately 0.001 Pa. The substrate temperature can be set at a temperature of 200°C or lower. Next, a mixture gas is introduced into the film forming chamber 101 and the internal pressure of the film forming chamber 101 is kept approximately constant by the pressure control valve 117. The internal pressure of the film forming chamber 101 is adjusted to be in a range of, for example, 200 Pa to 3000 Pa. As the mixture gas to be introduced into the film forming chamber 101, for example, a gas including a silane gas and a hydrogen gas can be used. The flow rate of the hydrogen gas is preferably approximately several times to several tens of times larger than that of the silane gas, more preferably 5 times or more and 30 times or less. In this case, the i-type amorphous layer 5c of good film quality can be formed.

After the internal pressure of the film forming chamber 101 is stabilized, an alternating electric power of several kHz to 80 MHz is inputted to the cathode electrode 102 to generate plasma between the cathode electrode 102 and the anode electrode 103, thereby forming the i-type amorphous layer 5c. The power density per unit area of the cathode electrode 102 can be in a range of 0.01 W/cm² to 0.3 W/cm².

Thus, the i-type amorphous layer 5c having a desired thickness is formed, and then input of the alternating electric power is stopped and the inside of the film forming chamber 101 is evacuated to a vacuum.

The thickness of the i-type amorphous layer 5c is preferably set at 0.05 µm to 0.25 µm in consideration of the amount of light absorption and deterioration of photoelectric conversion characteristics due to light degradation.

### 3-3-6. Step of forming n-type semiconductor layer

Next, the n-type semiconductor layer 5d is formed. First, the background pressure in the film forming chamber 101 is evacuated to a vacuum of approximately 0.001 Pa. The substrate temperature can be set at a temperature of 200°C or lower, for example 150°C. Next, a mixture gas is introduced into the film forming chamber 101 and the internal pressure of the film forming chamber 101 is kept approximately constant by the pressure control valve 117. The internal pressure of the film forming chamber 101 is adjusted to be in a range of, for example, 200 Pa to 3600 Pa. As the mixture gas to be introduced into the film forming chamber 101, a gas including a silane gas, a hydrogen gas, and a phosphine gas can be used. The flow rate of the hydrogen gas can be 5 times or more and 300 times or less larger than that of the silane gas, and it is preferably approximately 5 times to 30 times in the case of forming an n-type amorphous layer, and 30 times to 300 times in the case of forming an n-type microcrystalline layer.

After the internal pressure of the film forming chamber 101 is stabilized, an alternating electric power of several kHz to 80 MHz is inputted to the cathode electrode 102 to generate plasma between the cathode electrode 102 and the anode electrode 103, thereby forming an amorphous or microcrystalline n-type semiconductor layer 5d. The power density per unit area of the cathode electrode 102 is preferably in a range of 0.01 W/cm² to 0.3 W/cm² in the case of forming an n-type amorphous layer, and it is preferably in a range of 0.02 W/cm² to 0.5 W/cm² in the case of forming an n-type microcrystalline layer.

The thickness of the n-type semiconductor layer 5d is preferably 2 nm or more in order to provide an adequate internal electric field for the i-type amorphous layer 5c. On the other hand, the thickness of the n-type semiconductor layer 5d is preferably as small as possible in order to suppress the amount of light absorption in the n-type semiconductor layer 5d as an inactive layer, and it is generally adjusted to 50 nm or less.

Thus, the first photoelectric conversion layer 5 including the i-type amorphous layer 5c can be formed.

### 3-4. Step of forming second photoelectric conversion layer

Next, the second photoelectric conversion layer 7 is formed on the obtained substrate. As described above, the second photoelectric conversion layer 7 has the p-type semiconductor layer 7a, the buffer layer 7b, the i-type amorphous layer 7c, and the n-type semiconductor layer 7d, and the respective semiconductor layers are therefore formed in order.

Hereinafter, a step of forming the second photoelectric conversion layer 7 will be described in detail.

### 3-4-1. Gas replacement step

Next, a gas replacement step is performed in the same manner as in "3-3-1. Gas replacement step". By performing this gas replacement step, it is possible to reduce the amount of impurities released from the n-type semiconductor layer deposited on an inner wall and an electrode in the film forming chamber 101 during the formation of the n-type semiconductor layer 5d, particularly impurities that determine a conductive type of the n-type semiconductor layer 5d to be immixed in the p-type semiconductor layer 7a. Thereby, a semiconductor layer of good quality can be formed as the p-type semiconductor layer 7a. Here, since the p-type semiconductor layer 7a includes p-type conductive impurities in a concentration of approximately 1 × 10²⁰ cm⁻³, satisfactory photoelectric conversion characteristics are attained if the concentration of immixed n-type conductive impurities is approximately 1 × 10¹⁸ cm⁻³ or less, which is 2 digits less than the concentration of the p-type conductive impurities.

### 3-4-2. Step of forming p-type semiconductor layer

Next, the p-type semiconductor layer 7a is formed. The p-type semiconductor layer 7a can be formed in the same manner as in the formation of the p-type semiconductor layer 5a of the first photoelectric conversion layer 5.

### 3-4-3. Step of forming buffer layer

Next, the buffer layer 7b is formed in the same manner as in the formation of the buffer layer 5b of the first photoelectric conversion layer 5.

### 3-4-4. Gas replacement step

Next, a gas replacement step is performed in the same manner as in "3-3-1. Gas replacement step". In this gas replacement step, an effect identical or similar to that in the gas replacement step performed before the formation of the i-type amorphous layer 5c of the first photoelectric conversion layer 5 can be attained.

### 3-4-5. Step of forming i-type amorphous layer

Next, the i-type amorphous layer 7c is formed.

The thickness of the i-type amorphous layer 7c is preferably set at 0.1 µm to 0.7 µm in consideration of the amount of light absorption and deterioration of the photoelectric conversion characteristics due to light degradation.

Further, it is desirable that the bandgap of the i-type amorphous layer 7c of the second photoelectric conversion layer 7 is narrower than the bandgap of the i-type amorphous layer 5c of the first photoelectric conversion layer 5. This is because, by forming such a bandgap, light of wavelength band that the first photoelectric conversion layer 5 cannot absorb can be absorbed in the second photoelectric conversion layer 7, and incident light can be utilized effectively.

In order to narrow the bandgap of the i-type amorphous layer 7c, the substrate temperature during the film formation can be set at a higher temperature. By increasing the substrate temperature, the concentration of hydrogen atoms contained in the film can be reduced and an i-type amorphous layer 7c having a small bandgap can be formed. That is, it is only necessary to adopt a substrate temperature for the formation of the i-type amorphous layer 7c of the second photoelectric conversion layer 7 higher than the substrate temperature for the formation of the i-type amorphous layer 5c of the first photoelectric conversion layer 5. Thereby, it is possible to make the concentration of hydrogen atoms in the i-type amorphous layer 5c of the first photoelectric conversion layer 5 higher than the concentration of hydrogen atoms in the i-type amorphous layer 7c of the second photoelectric conversion layer 7 and to produce a stacked thin-film solar cell module in which the bandgap of the i-type amorphous layer 5c of the first photoelectric conversion layer 5 is wider than the bandgap of the i-type amorphous layer 7c of the second photoelectric conversion layer 7.

Further, by decreasing the flow rate ratio of a hydrogen gas to a silane gas of a mixture gas to be introduced into the film forming chamber 101 in the formation of the i-type amorphous layer 7c, the concentration of hydrogen atoms contained in the i-type amorphous layer 7c can be reduced and the i-type amorphous layer 7c having a narrow bandgap can be formed. That is, it is only necessary to adopt a flow rate ratio of the hydrogen gas to the silane gas of the mixture gas in the formation of the i-type amorphous layer 7c of the second photoelectric conversion layer 7 smaller than that in the formation of the i-type amorphous layer 5c of the first photoelectric conversion layer 5. Thereby, it is possible to make the concentration of hydrogen atoms in the i-type amorphous layer 5c of the first photoelectric conversion layer 5 higher than the concentration of hydrogen atoms in the i-type amorphous layer 7c of the second photoelectric conversion layer 7 and to produce a stacked thin-film solar cell module in which the bandgap of the i-type amorphous layer 5c of the first photoelectric conversion layer 5 is wider than the bandgap of the i-type amorphous layer 7c of the second photoelectric conversion layer 7.

Furthermore, it is also possible to adjust the bandgap of the i-type amorphous layer by selecting either forming the i-type amorphous layer by continuous discharge plasma or forming the i-type amorphous layer by pulse discharge plasma. When the i-type amorphous layer is formed by continuous discharge plasma, the concentration of hydrogen atoms contained into the i-type amorphous layer to be formed can be made higher than that in the case of forming the i-type amorphous layer by pulse discharge plasma.

Accordingly, it is possible to produce a stacked thin-film solar cell module in which the bandgap of the i-type amorphous layer 5c of the first photoelectric conversion layer 5 is wider than the bandgap of the i-type amorphous layer 7c of the second photoelectric conversion layer 7 by switching supply electric power for generating plasma so that the i-type amorphous layer 5c of the first photoelectric conversion layer 5 can be formed by continuous discharge plasma and the i-type amorphous layer 7c of the second photoelectric conversion layer 7 can be formed by pulse discharge plasma.

The setting of the substrate temperatures for the formation of the i-type amorphous layer 5c of the first photoelectric conversion layer 5 and the i-type amorphous layer 7c of the second photoelectric conversion layer 7, the setting of the flow rate ratio of the hydrogen gas to the silane gas, and the setting of the switching between the continuous discharge and the pulse discharge may be done separately, or the respective settings may be used in combination. In particular, when the substrate temperatures for the formation of the i-type amorphous layer 5c of the first photoelectric conversion layer 5 and the i-type amorphous layer 7c of the second photoelectric conversion layer 7 are the same, concurrent use of the setting of the flow rate ratio of the hydrogen gas to the silane gas and the switching between the continuous discharge and the pulse discharge is desirable, because it allows the concentration of hydrogen atoms contained in the i-type amorphous layer to be changed by a large amount.

### 3-4-6. Step of forming n-type semiconductor layer

Next, the n-type semiconductor layer 7d is formed. The n-type semiconductor layer 7d can be formed in the same manner as in the formation of the n-type semiconductor layer 5d of the first photoelectric conversion layer 5.

### 3-5. Step of forming third photoelectric conversion layer

Next, the third photoelectric conversion layer 9 is formed on the obtained substrate. As described above, the third photoelectric conversion layer 9 has the p-type semiconductor layer 9a, the i-type microcrystalline layer 9b, and the n-type semiconductor layer 9c, and the respective semiconductor layers are therefore formed in order.

Hereinafter, a step of forming the third photoelectric conversion layer 9 will be described in detail.

### 3-5-1. Gas replacement step

First, a gas replacement step is performed in the same manner as in "3-3-1. Gas replacement step". This gas replacement step has an effect identical or similar to that in the gas replacement step performed before the formation of the second photoelectric conversion layer 7.

### 3-5-2. Step of forming p-type semiconductor layer

Next, the p-type semiconductor layer 9a is formed. The p-type semiconductor layer 9a can be formed in the same manner as in the formation of the p-type semiconductor layer 5a of the first photoelectric conversion layer 5.

### 3-5-3. Gas replacement step

Next, a gas replacement step is performed in the same manner as in "3-3-1. Gas replacement step". This gas replacement step has an effect identical or similar to that in the gas replacement step performed before the formation of the i-type amorphous layer 5c of the first photoelectric conversion layer 5 and the i-type amorphous layer 7c of the second photoelectric conversion layer 7.

### 3-5-4. Step of forming i-type microcrystalline layer

Next, the i-type microcrystalline layer 9b is formed. The i-type microcrystalline layer 9b can be formed, for example, under the following formation conditions. The substrate temperature is desirably set at a temperature of 200°C or lower. The internal pressure of the film forming chamber 101 during the formation of the layer is desirably in a range of 240 Pa to 3600 Pa. Further, the power density per unit area of the cathode electrode 102 is desirably set to be in a range of 0.02 W/cm² to 0.5 W/cm².

As a mixture gas to be introduced into the film forming chamber 101, for example, a gas including a silane gas and a hydrogen gas may be used. The flow rate of the hydrogen gas is desirably approximately 30 times to several hundreds of times larger than that of the silane gas, more desirably approximately 30 times to 300 times.

The thickness of the i-type microcrystalline layer 9b is preferably 0.5 µm or more, more preferably 1 µm or more in order to secure an adequate amount of light absorption. On the other hand, the thickness of the i-type microcrystalline layer 9b is preferably 20 µm or less, more preferably 15 µm or less in order to secure good productivity.

Thus, an i-type microcrystalline layer 9b having a good crystallinity, in which the intensity ratio I₅₂₀/I₄₈₀) of a peak at 520 nm⁻¹ to a peak at 480 nm⁻¹, measured by Raman spectroscopy, is in a range of 3 to 10 can be formed.

### 3-5-5. Step of forming n-type semiconductor layer

Next, the n-type semiconductor layer 9c is formed. The n-type semiconductor layer 9c can be formed in the same manner as in the formation of the n-type semiconductor layer 5d of the first photoelectric conversion layer 5.

### 3-6. Step of forming photoelectric conversion layer division line

Next, the photoelectric conversion layer division line is formed in the first to third photoelectric conversion layers 5, 7, 9 so as to extend in the crosswise direction (in the X direction in FIG. 1) and so as to be off the position of the front surface electrode division line 13, thereby dividing the first to third photoelectric conversion layers 5, 7, 9 into a pattern of a plurality of band-like shapes. The photoelectric conversion layer division line can be formed by scribing the first to third photoelectric conversion layers 5, 7, 9 by use of second higher harmonics of a YAG laser, for example. Here, the contact lines 17 are formed of a conductor (for example, the material for the rear surface electrodes) with which the photoelectric conversion layer dividing lines are filled in, and therefore the width of the photoelectric conversion layer dividing lines is the same as the width of the contact lines 17.

### 3-7. Step of forming rear surface electrode

Next, the rear surface electrode 11 is formed on the third photoelectric conversion layer 9. The rear surface electrode 11 has a transparent conductive film and a metal film in this order from a side of the third photoelectric conversion layer 9, and these films are therefore formed in order.

The transparent conductive film is formed of SnO2, ITO, ZnO, or the like. The metal film is formed of a metal such as silver and aluminum. The transparent conductive film and the metal film are formed by a method such as a CVD method, a sputtering method, and a vapor deposition method. The transparent conductive film may be omitted.

When the rear surface electrode 11 is formed, a material of the rear surface electrode 11 gets into the photoelectric conversion layer division line to form the contact line 17.

### 3-8. Step of forming rear surface electrode division line

Next, the rear surface electrode division line 29 extending in the crosswise direction (in the X direction in FIG. 1) is formed in the rear surface electrode 11 and the first to third photoelectric conversion layers 5, 7, 9, thereby dividing the rear surface electrode 11 and the first to third photoelectric conversion layers 5, 7, 9 into a pattern of a plurality of band-like shapes. The rear surface electrode division line 29 is formed so that the three lines are arranged in order of the front surface electrode division line 13, the photoelectric conversion layer division line, and the rear surface electrode division line 29.

The rear surface electrode division line 29 can be formed by scribing the rear surface electrode 11 and the first to third photoelectric conversion layers 5, 7, 9 by use of second higher harmonics of a YAG laser, for example.

Through the steps that have been described so far, the band-shaped cell string 21 having the plurality of cells 27 connected to each other in series is obtained.

### 3-9. Step of Forming Alignment Dividing Lines

Next, alignment dividing lines 25 running in the lengthwise direction (the direction Y in FIG. 1, the direction in which the shorter sides of the substrate 2 run, the direction in which a plurality of solar cells 27 are aligned in the cell strings 21) are formed in the band-like cell string 21 so that the band-like cell string 21 is divided into a plurality of cell strings 21. At this time, the locations where the alignment dividing lines 25 are formed are adjusted so that the width of the cell strings 21 at the ends can be smaller than the width of the other cell strings 21. In addition, the width of the cell strings may be the width of the cell strings in the present invention.

The Alignment dividing line 25 can be formed by scribing the rear surface electrode 11 and the first to third photoelectric conversion layers 5, 7, 9 by use of second higher harmonics of a YAG laser, for example, and by further scribing the front surface electrode 3 by use of a fundamental wave of a YAG laser.

### 3-10. Step of forming common electrode

Next, the common electrode 23 is installed so that the plurality of cell strings 21 are connected to each other in parallel to complete production of the thin-film solar cell module 1 of this embodiment.

### 4. RB Current Measuring Test

As described below, the RB current (current when a voltage of from 5 V to 8 V is applied in the direction opposite to the direction of the current due to the photovoltaic power) was measured while changing the width of the cell strings 21. Here, the greater the RB current is, the easier the leak current flows. In this test, the solar cell through which an RB current of 50 mA or more flowed was used as the standard for the flowing leak current. First, samples having the same structure as the thin-film solar cell module according to the above-described embodiment, which is described in reference to FIGs. 1, 2 and 3 (here, there were no alignment dividing lines 25 or common electrodes 23 and the third photoelectric conversion layer was not formed), were fabricated with the materials in Table 1. The number of connections of the samples in series (the number of solar cells included in each cell string) was 100. Here, the used substrate had a width of 1400 mm in the direction in which the cell string was divided, and regions of 10 mm where a photoelectric conversion layer was not formed were provided at both ends in the direction in which the cell string was divided.

**[Table 1]**

| Element | | Material |
|---|---|---|
| Substrate | | Glass |
| First electrode | | SnO₂ (surface is uneven) |
| First photoelectric conversion layer | P-type semiconductor layer (amorphous layer) | Amorphous silicon carbide |
| | Buffer layer | Amorphous silicon carbide |
| | I-type amorphous layer | Amorphous silicon |
| | N-type semiconductor layer (amorphous layer) | Amorphous silicon |
| Second photoelectric conversion layer | P-type semiconductor layer (microcrystalline layer) | Microcrystalline silicon |
| | I-type microcrystalline laver | Microcrystalline silicon |
| | N-type semiconductor layer (microcrystalline layer) | Microcrystalline silicon |
| Second electrode | Transparent conductive film | ZnO |
| | Metal film | Ag |

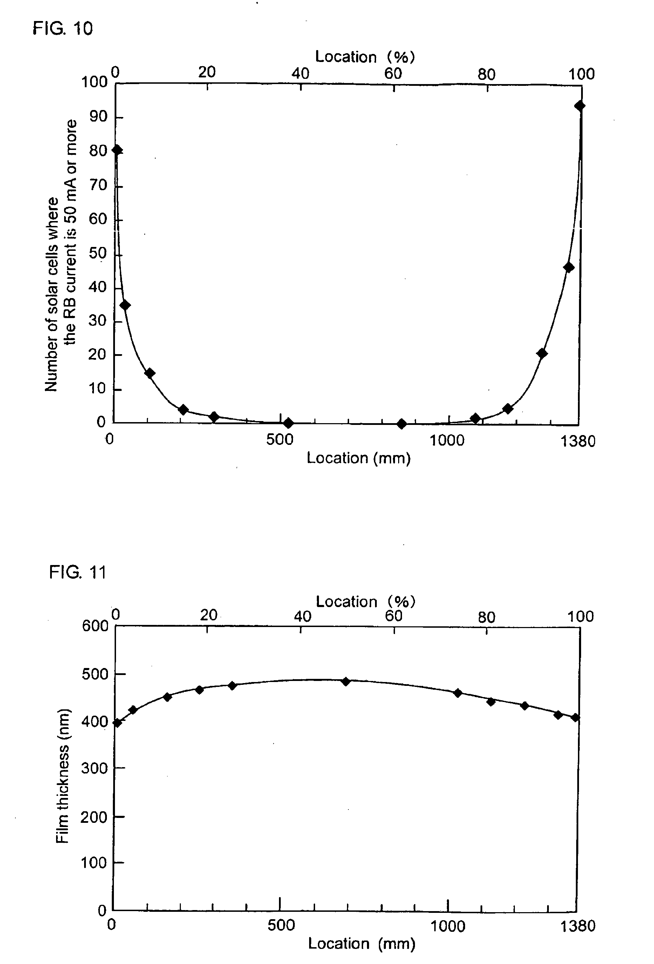

Next, alignment dividing lines were formed so that the cell strings had widths of the cell strings shown in Table 2 (in this order). The RB current (current when a voltage of 5 V is applied in the opposite direction) and I-V were measured for the solar cells of the fabricated samples. Table 2 shows the width (mm) of the cell strings gained by dividing the fabricated samples in this order, the width (%) of each cell string relative to the sum of the widths of all the cell strings, and the number of solar cells where the RB current included in each cell string is 50 mA or more. In addition, FIG. 10 is a graph showing the relationship between the location of the center of each cell string and the number of solar cells having an RB current of 50 mA or more. Here, the lateral axis in FIG. 10 indicates the location (mm) in the direction in which the region where the first photoelectric conversion layer and the like are formed on a substrate is divided into cell strings, and one end is 0. In addition, the location of the center of each cell string is the location of the center in this direction. Furthermore, the upper side of the graph indicates the location (%) of each cell string when the sum of the widths of all the cell strings is 100%. As can be seen from Table 2, the number of solar cells having an RB current of 50 mA or more was 0 in the location range from 355 mm to 1025 mm in FIG. 10 (6^{th} and 7^{th} cell strings from the left in Table 2), and all the absolute values of the RB current in the cells connected in series within the cell string were 0.05 mA/cm² or less.

**[Table 2]**

| | | | | | | | | | | | | |
|---|---|---|---|---|---|---|---|---|---|---|---|---|
| Width of cell string (mm) | 5 | 50 | 100 | 100 | 100 | 335 | 335 | 100 | 100 | 100 | 50 | 5 |
| Ratio of width of cell string (%) | 0.36 | 3.6 | 7.2 | 7.2 | 7.2 | 24 | 24 | 7.2 | 7.2 | 7.2 | 3.6 | 0.36 |
| Number of solar cells having an RB current of 50 mA or more | 81 | 35 | 15 | 4 | 2 | 0 | 0 | 2 | 5 | 21 | 47 | 94 |

It can be seen from Table 2 and FIG. 10 that there are no solar cells having an RB current of 50 mA or more in the cell strings close to the center included in the cell module, and the number of solar cells having an RB current of 50 mA or more is greater in the cell strings closer to an end of the cell module. It can be seen that there are particularly a great number of solar cells having an RB current of 50 mA or more in the cell strings of which the width is 5 mm, 50 mm and 100 mm from an end. In addition, it has become clear that the number of solar cells having an RB current of 50 mA or more starts increasing outside the location of approximately 20% from either end of the cell module and the number of solar cells having an RB current of 50 mA or more further increases outside the location of approximately 10% from either end of the cell module.

Furthermore, as described above, the number of solar cells having an RB current of 50 mA or more is small in a range from 355 mm to 1025 mm, and therefore a leak current is considered to be small. In addition, there was no film peeling even when the power output of the cell string was great in the below described hot spot withstanding test in this range.

The distribution of the film thickness of the first photoelectric conversion layer was also checked. FIG. 11 shows the results of the film thickness distribution measurement. FIG. 11 is a graph showing the film thickness distribution of the first photoelectric conversion layer for each location of the cell string in the direction in which the cell string of the fabricated sample was divided. Here, the lateral axis in FIG. 11 indicates the location (mm) of the region in which the first photoelectric conversion layer and the like are formed on the substrate in the direction in which the cell string is divided, and one end is 0. In addition, the upper side of the graph indicates the location (%) of the cell string relative to the sum of the widths of all the cell strings.

It can be seen from the film thickness distribution measurement that the film thickness is stable at the center, but the film thickness is lower close to an end.

The reason why the number of solar cells having an RB current of 50 mA or more increases as the location is closer to an end of the cell module is unclear. However, the location where the film thickness of the first photoelectric conversion layer is smaller by approximately 10% and the location where the number of solar cells having an RB current of 50 mA or more increases are the same, and therefore this is one possible reason as to why the number of solar cells having an RB current of 50 mA or more increases as the location is closer to an end of the cell module.

### 5. Cell hotspot resistance test

A cell hotspot resistance test was performed by the following method.

First, a large number of samples having the same configuration (except that there is no Alignment dividing line 25 and no common electrode 23) as that of the thin-film solar cell module of the embodiment described above with reference to FIG. 1, FIG. 2, FIG. 3 were produced by using materials shown in Table 3. The number of series connection stages of each sample was 30.

**Table 3**

| Element | | Material |
|---|---|---|
| Substrate 2 | | Glass |
| First electrode 3 | | SnO₂ (projection-and-recess shape on surface) |
| First photoelectric conversion layer 5 | P-type semiconductor layer 5a (amorphous layer ) | Amorphous silicon carbide |
| | Buffer layer 5b | Amorphous silicon carbide |
| | I-type amorphous layer 5c | Amorphous silicon |
| | N-type semiconductor layer 5d (amorphous layer) | Amorphous silicon |
| Second photoelectric conversion layer 7 | P-type semiconductor layer 7a (amorphous layer) | Amorphous silicon carbide |
| | Buffer layer 7b | Amorphous silicon carbide |
| | I-type amorphous layer 7c | Amorphous silicon |
| | N-type semiconductor layer 7d (amorphous layer) | Amorphous silicon |
| Third photoelectric conversion layer conversion layer 9 | P-type semiconductor layer 9a (microcrystalline layer) | Microcrystalline silicon |
| | I-type microcrystalline layer 9b | Microcrystalline silicon |
| | N-type semiconductor layer 9c (microcrystalline layer ) | Microcrystalline silicon |
| Second electrode 11 | Transparent conductive film | ZnO |
| | Metal film | Ag |

Each sample produced was measured for an I-V property and an RB current (a current when a voltage of 5 V to 8 V was applied in a reverse direction; the voltage applied was appropriately varied so that the RB current values shown in Table 4 were obtained).

Next, samples that are different from one another in RB current were selected out of the above-described samples. Each of the selected samples was divided in parallel, thereby obtaining a 5 W to 50 W of output of the cell string 21 being evaluated.

Next, the hotspot resistance test was performed on a cell 27 having the smallest area in the cell string 21 for judgment of acceptance with defining a peeled area of less than 10% as an acceptance line. The hotspot resistance test was performed in accordance with IEC 61646 1st EDITION.

As the peeled area, a surface of the sample was photographed from the side of the substrate 2, the contrast of an obtained image was increased to obtain a monochrome image, and a percentage of the area accounted for by the white part in this image was calculated. Since a part that experienced peel-off of a film usually has a larger luminance, the percentage of the area of the white part obtained in the above-described manner corresponds to the percentage of the area of the part that experienced peel-off of a film (peeled area).

Table 4 shows a result obtained. Table 4 shows the results of the measurement of the area where peeling occurred for 54 types of samples having different outputs of the cell strings 21 or different RB currents. Here, the area where peeling occurred exceeded 10% in the samples indicated by dashes.

**Table 4**

| | | | | | | | | | |
|---|---|---|---|---|---|---|---|---|---|
| Output from entire sample (W) | 85 | 84 | 100 | 120 | 100 | 90 | 120 | 90 | 100 |
| Number of parallel division stages (number of cell strings) | 17 | 12 | 10 | 10 | 5 | 3 | 3 | 2 | 2 |
| Output from cell string→ RB current↓ | 5W | 7 W | 10 W | 12 W | 20 W | 30 W | 40 W | 45W | 50 W |
| 0.019 mA/ cm² | 0.1% | 0.2% | 1.5% | 2.3% | 3.5% | 4.1% | 4.8% | 5.5% | 6.2% |
| 0.084 mA/cm² | 0.8% | 1.0% | 1.7% | 2.5% | 3.9% | 4.6% | 5.1% | 5.8% | 6.5% |
| 0.31 mA/cm² | 0.9% | 1.5% | 2.1% | 4.5% | 5.1% | 6.5% | - | - | - |
| 2.06 mA/cm² | 1.0% | 1.7% | 2.6% | 4.8% | 5.8% | 7.2% | - | - | - |
| 2.29 mA/cm² | 0.7% | 1.0% | 1.7% | 2.6% | 4.1% | 4.8% | 5.3% | 5.8% | 6.4% |
| 6.44 mA/cm² | 0.1% | 0.1% | 1.2% | 2.3% | 3.7% | 4.1% | 4.5% | 5.2% | 5.8% |

Table 4 has revealed that the samples are unlikely to experience peel-off of a film in both the case where the magnitude of the RB current is very small (0.019 mA/cm²) and the case where the magnitude of the RB current is very large (6.44 mA/cm²), and the samples are likely to experience peel-off of a film in the case where the magnitude of the RB current is moderate (0.31 to 2.06 mA/cm²), even if the output from the cell string 21 is the same.

It has been also revealed that the peeled area can be held to 10% or less regardless of the value of the RB current, when the output from the cell string is 30 W or less.

### 6. Reverse overcurrent resistance test

Next, a reverse overcurrent resistance test was performed in the following manner.

First, samples having the same configuration as that of the thin-film solar cell module of the embodiment described above with reference to FIG. 1, FIG. 2, FIG. 3 were produced by using materials shown in Table 3. The number of series connection stages of each sample was 30.

Next, the reverse overcurrent resistance test was performed by examining whether or not the contact line 17 was damaged when an overcurrent was applied to the produced samples in a reverse direction (the reverse direction referred to means a direction opposite to a direction in which a current passes when the solar cell is in light, that is, it would be a forward direction in the case where the solar cell not in light is considered a diode).

According to the provisions of IEC 61730, the current to be applied here needs to be 1.35 times the anti-overcurrent specification value, and was set to 5.5 A at 70 V here.

Here, when a current is applied to one cell module under the above-described condition, it is apt to be considered that the current will be divided equally to be applied to each cell string connected in parallel. Actually, however, the current can be concentrated in a particular cell string, because the resistance value varies from string to string. On the assumption that this is the worst case situation, problems must be prevented from occurring even when 70 V × 5.5 A = 385 W is applied to one cell string. Therefore, a power of 70 V × 5.5 A = 385 W was applied to one cell string 21 to carry out the test.

Samples of 20 types that are different from one another in length L or width W of the cross-section of the contact line 17 were produced to carry out the test. It was judged by visual observation whether or not the contact line 17 was damaged. The contact line 17 was judged to have been damaged when there was discoloring or peel-off in the rear surface electrode 11 in a half oval shape along the contact line 21. Table 5 shows a result obtained.

**Table 5**

| Length L of cross-section of contact line (cm)→ | 37.5 | 30 | 22.5 | 18 | 15 | 12.9 | 11.3 | 10 | 9 | 8.2 |
|---|---|---|---|---|---|---|---|---|---|---|
| Width W of cross-section of contact line↓ | | | | | | | | | | |
| 20 µm | ○ | ○ | ○ | ○ | × | × | × | × | × | × |
| 40 µm | ○ | ○ | ○ | ○ | ○ | ○ | ○ | ○ | ○ | × |

Table 5 has revealed that when the width W of the cross-section of the contact line 17 is 20 µm and 40 µm, damage to the contact line 17 can be prevented by setting the length L of the cross-section of the contact line 17 to 18 cm or more and 9 cm or more, respectively. In other words, it has been revealed that the cross-sectional area Sc of the contact line 17 should be 20 µm × 18 cm = 0.036 cm² or more, or 40 µm × 9 cm = 0.036 cm² or more.

Furthermore, it has been revealed that (power applied to cell string 21) / (area Sc of contact line 17) ≅ 10.7 kW/cm², because the power applied to the cell string 21 was 385 W, and therefore damage to the contact line 17 can be prevented when the power density applied to the contact line 21 is 10.7 kW/cm² or less.

Here, the above-described cell strings within 18% from both ends shown in Table 2 have a sufficiently large leak path within cells judging from the results of the RB test, and the current does not concentrate on the contact lines but is dispersed, making the power consumed in the contact line small. In such a case, the contact line can be prevented from being damaged even when the above-described relationship is not met.

### DESCRIPTION OF THE REFERENCE NUMERALS

- 1: Thin-film solar cell module
- 1a: Cell module
- 2: Substrate
- 3: Front surface electrode
- 5: First photoelectric conversion layer
- 7: Second photoelectric conversion layer
- 9: Third photoelectric conversion layer
- 11: Rear surface electrode
- 5a: P-type semiconductor layer
- 5b: Buffer layer
- 5c: I-type amorphous layer
- 5d: N-type semiconductor layer
- 7a: P-type semiconductor layer
- 7b: Buffer layer
- 7c: I-type amorphous layer
- 7d: N-type semiconductor layer
- 9a: P-type semiconductor layer
- 9b: I-type microcrystalline layer
- 9c: N-type semiconductor layer
- 13: Front surface electrode division line
- 17: Contact line
- 21: Cell string
- 23: Common electrode
- 25: Alignment dividing line
- 27: Solar cell
- 29: Rear surface electrode division line
- 31: Blocking diode
- 101: Film forming chamber
- 102: Cathode electrode
- 103: Anode electrode
- 105: Impedance matching circuit
- 106a: Power introducing line
- 106b: Power introducing line
- 107: Substrate
- 108: Power supply section
- 110: Gas intake section
- 116: Gas exhaust section
- 117: Pressure control valve
- 118: Gas
- 119: Gas exhaust outlet
- 150: Thin-film solar cell array
- 201: Substrate
- 202: Cell string
- 203: Solar cell
- 204: Common electrode
- 210: Thin-film solar cell module
- 251: Front surface electrode
- 253: Photoelectric conversion layer
- 255: Rear surface electrode
- 258: Particle of material

## Claims

1. A thin-film solar cell module (1), comprising:
a substrate (2); and
a cell module (1a) comprising three or more cell strings (21), each of which has a constant width, and a first common electrode (23) and a second common electrode (23) for electrically connecting the cell strings (21), wherein
each cell string (21) comprises a plurality of solar cells (27) having the same width as the cell string (21) and connected in series,
the cell strings (21) have the same length as the solar cells (27) connected in series and are provided on the substrate (2) so as to be aligned in the direction perpendicular to the direction in which the solar cells (27) are connected in series,
each cell string (21) comprises two electrodes, one of which is electrically connected to the first common electrode (23) and the other is electrically connected to the second common electrode (23),
the solar cells (27) respectively comprise a front surface electrode (3), a photoelectric conversion layer (5, 7, 9) and a rear surface electrode (11) layered in this order,
each cell string (21) has contact lines (17) having the same width as the cell string (21) and electrically connecting the front surface electrode (3) of a first solar cell (27) to the rear surface electrode (11) of a second solar cell (27), the first and second solar cells (27) being included in the cell string (21) and adjacent to each other,
the cell strings (21) at both ends in the three or more cell strings (21) have a width narrower than the other cell strings (21), and
the cell strings (21) at both ends in the three or more cell strings (21) have a width of 5 mm or more and 255 mm or less.

2. The thin-film solar cell module according to claim 1, wherein the cell strings (21) at both ends in the three or more cell strings (21) have a width of 0.36 % or more and 18 % or less of the sum of the widths of all the cell strings (21) included in the cell module (1a).

3. The thin-film solar cell module (1) according to claim 1, wherein the cell module (1a) includes five or more cell strings (21), and the sum of the widths of the two cell strings (21) next to each other, including at least either end of the cell strings (21) in the five or more cell strings (21), is 11 mm or more and 255 mm or less, or 0.71 % or more and 18 % or less of the sum of the widths of all the cell strings (21) included in the cell module (1a).

4. The thin-film solar cell module (1) according to claim 1, wherein the cell module (1a) includes seven or more cell strings (21), and the sum of the widths of the three cell strings (21) next to each other, including at least either end of the cell strings (21) in the seven or more cell strings (21), is 17 mm or more and 255 mm or less, or 1.07 % or more and 18 % or less of the sum of the widths of all the cell strings (21) included in the cell module (1a).

5. The thin-film solar cell module (1) according to any of claims 1 to 4, wherein the cell strings (21) are configured to have an output of 30 W or less under such conditions that the light source is a xenon lamp, the irradiance is 100 mW/cm², AM is 1.5, and the temperature is 25°C.

6. The thin-film solar cell module (1) according to any of claims 1 to 5, wherein each cell string (21) has two electrodes, one of which is electrically connected to the first common electrode (23) and the other is electrically connected to the second common electrode (23), the cell strings (21) other than the cell strings (21) at both ends in the cell strings (21) satisfy that (P-Ps)/Sc is 10.7 (kW/cm²) or less where the output of the cell module (1a) is P (W), the output of the cell strings (21) is Ps (W), and the area of the cross section of the contact lines (17) included in the cell strings (21) is Sc (cm²) under such conditions that the light source is a xenon lamp, the irradiance is 100 mW/cm², AM is 1.5, and the temperature is 25°C.

7. The thin-film solar cell module (1) according to any of claims 1 to 6, wherein
the cell string (21) at the center in the cell strings (21) has a width greater than that of the other cell strings (21).

8. The thin-film solar cell module (1) according to claim 7, wherein the cell string (21) at the center has a width of 670 mm or less or a width of 50 % or less of the sum of the widths of all cell strings (21) included in the cell module (1a).

9. The thin-film solar cell module (1) according to any of claims 1 to 8, wherein the front surface electrode (3) is made of a transparent conductive film made of an oxide including Sn and the rear surface electrode (11) has a multilayer structure of a transparent conductive film and a metal film.

10. The thin-film solar cell module (1) according to any of claims 1 to 9, wherein the cell module (1) is configured to have an output of 90 W or more and 385 W or less under such conditions that the light source is a xenon lamp, the irradiance is 100 mW/cm², AM is 1.5, and the temperature is 25°C.

## Patentansprüche

1. Dünnschichtsolarzellenmodul (1) mit:
einem Substrat (2); und
einem Zellenmodul (1a) mit drei oder mehr Zellenfolgen (21), von denen jede eine konstante Breite aufweist, und mit einer ersten gemeinsamen Elektrode (23) und einer zweiten gemeinsamen Elektrode (23) zum elektrischen Verbinden der Zellenfolgen (21), wobei
jede Zellenfolge (21) eine Mehrzahl von Solarzellen (27) aufweist, die die gleiche Breite wie die Zellenfolge (21) aufweisen und in Reihe geschaltet sind,
die Zellenfolgen (21) die gleiche Länge wie die in Reihe geschalteten Solarzellen (27) aufweisen und derart auf dem Substrat (2) angeordnet sind, dass sie in der zu der Richtung, in der die Solarzellen (27) in Reihe geschaltet sind, senkrechten Richtung ausgerichtet sind,
jede Zellenfolge (21) zwei Elektroden aufweist, von denen eine elektrisch mit der ersten gemeinsamen Elektrode (23) und die andere elektrisch mit der zweiten gemeinsamen Elektrode (23) verbunden ist,
die Solarzellen (27) jeweils eine Vorderseitenoberflächenelektrode (3), eine fotoelektrische Konversionsschicht (5, 7, 9) und eine Hinterseitenoberflächenelektrode (11) aufweisen, die in dieser Reihenfolge geschichtet sind,
jede Zellenfolge (21) Kontaktverbindungen (17) aufweist, die die gleiche Breite wie die Zellenfolge (21) aufweisen und die Vorderseitenoberflächenelektrode (3) einer ersten Solarzelle (27) mit der Hinterseitenoberflächenelektrode (11) einer zweiten Solarzelle (27) elektrisch verbinden, wobei die erste und die zweite Solarzelle (27) in der Zellenfolge (21) enthalten sind und nebeneinander angeordnet sind,
die Zellenfolgen (21) an beiden Enden der drei oder mehr Zellenfolgen (21) eine Breite aufweisen, die schmaler ist als die der anderen Zellenfolgen (21), und
die Zellenfolgen (21) an beiden Enden der drei oder mehr Zellenfolgen (21) eine Breite von 5 mm oder mehr und 255 mm oder weniger aufweisen.

2. Dünnschichtsolarzellenmodul nach Anspruch 1, wobei die Zellenfolgen (21) an beiden Enden der drei oder mehr Zellenfolgen (21) eine Breite von 0,36 % oder mehr und 18 % oder weniger der Summe der Breiten aller in dem Zellenmodul (1a) enthaltenen Zellenfolgen (21) aufweisen.

3. Dünnschichtsolarzellenmodul (1) nach Anspruch 1, wobei das Zellenmodul (1a) fünf oder mehr Zellenfolgen (21) aufweist und die Summe der Breiten der zwei benachbarten Zellenfolgen (21), die zumindest eines der Enden der Zellenfolgen (21) der fünf oder mehr Zellenfolgen (21) aufweisen, 11 mm oder mehr und 255 mm oder weniger, oder 0,71 % oder mehr und 18 % oder weniger der Summe der Breite aller in dem Zellenmodul (1a) enthaltenen Zellenfolgen (21) beträgt.

4. Dünnschichtsolarzellenmodul (1) nach Anspruch 1, wobei das Zellenmodul (1a) sieben oder mehr Zellenfolgen (21) aufweist und die Summe der Breiten von drei benachbarten Zellenfolgen (21), die zumindest eines der Enden der Zellenfolgen (21) der sieben oder mehr Zellenfolgen (21) aufweisen, 17 mm oder mehr und 255 mm oder weniger, oder 1,07 % oder mehr und 18 % oder weniger der Summe der Breiten aller in dem Zellenmodul (1a) enthaltenen Zellenfolgen (21) beträgt.

5. Dünnschichtsolarzellenmodul (1) nach einem der Ansprüche 1 bis 4, wobei die Zellenfolgen (21) geeignet sind, eine Leistung von 30 W oder weniger aufzuweisen, unter Bedingungen, in denen die Lichtquelle eine Xenonlampe, die Bestrahlungsdichte 100 mW/cm², AM 1.5 und die Temperatur 25°C ist.

6. Dünnschichtsolarzellenmodul (1) nach einem der Ansprüche 1 bis 5, wobei
jede Zellenfolge (21) zwei Elektroden aufweist, von denen eine elektrisch mit der ersten gemeinsamen Elektrode (23) und die andere elektrisch mit der zweiten gemeinsamen Elektrode (23) verbunden ist,
die Zellenfolgen (21) mit Ausnahme der Zellenfolgen (21) an beiden Enden der Zellenfolgen (21) erfüllen, dass (P-Ps)/Sc 10,7 (kW/cm²) ist oder weniger ist, wobei die Leistung des Zellenmoduls (1a) P(W) beträgt, die Leistung der Zellenfolgen (21) Ps(W) beträgt und die Querschnittsfläche der Kontaktverbindungen (17), die in den Zellenfolgen (21) enthalten sind, Sc (cm²) beträgt, unter Bedingungen, in denen die Lichtquelle eine Xenonlampe, die Bestrahlungsdichte 100 mW/cm², AM 1.5 und die Temperatur 25°C ist.

7. Dünnschichtsolarzellenmodul (1) nach einem der Ansprüche 1 bis 6, wobei
die Zellenfolge (21) in der Mitte der Zellenfolgen (21) eine größere Breite als die der anderen Zellenfolgen (21) aufweist.

8. Dünnschichtsolarzellenmodul (1) nach Anspruch 7, wobei die Zellenfolge (21) in der Mitte eine Breite von 670 mm oder weniger oder eine Breite von 50 % oder weniger der Summe der Breiten aller in dem Zellenmodul (1a) enthaltenen Zellenfolgen (21) beträgt.

9. Dünnschichtsolarzellenmodul (1) nach einem der Ansprüche 1 bis 8, wobei die Vorderseitenoberflächenelektrode (3) aus einer transparenten leitfähigen Schicht ausgebildet ist, die aus einem Sn aufweisenden Oxid ausgebildet ist, und die Hinterseitenoberflächenelektrode (11) eine Mehrschichtstruktur aus einer transparenten leitfähigen Schicht und einer Metallschicht aufweist.

10. Dünnschichtsolarzellenmodul (1) nach einem der Ansprüche 1 bis 9, wobei das Zellenmodul (1) geeignet ist, eine Leistung von 90 W oder mehr und 385 W oder weniger aufzuweisen, unter Bedingungen, in denen die Lichtquelle eine Xenonlampe, die Bestrahlungsdichte 100 mW/cm², AM 1.5, und die Temperatur 25°C ist.

## Revendications

1. Module de cellules solaires à couche mince (1) comprenant :
un substrat (2) ; et
un module de cellules (1a) comprenant trois chaînes de cellules (21) ou plus, chacune présentant une largeur constante, et une première électrode commune (23) et une seconde électrode commune (23) pour la connexion électrique des chaînes de cellules (21), étant précisé
que chaque chaîne de cellules (21) comprend plusieurs cellules solaires (27) qui présentent la même largeur que la chaîne de cellules (21) et qui sont montées en série,
que les chaînes de cellules (21) présentent la même longueur que les cellules solaires (27) montées en série et sont prévues sur le substrat (2) de manière à être alignées dans la direction perpendiculaire à la direction dans laquelle les cellules solaires (27) sont montées en série,
que chaque chaîne de cellules (21) comprend deux électrodes, l'une étant connectée électriquement à la première électrode commune (23) tandis que l'autre est connectée électriquement à la seconde électrode commune (23),
que les cellules solaires (27) comprennent respectivement une électrode de surface avant (3), une couche de conversion photoélectrique (5, 7, 9) et une électrode de surface arrière (11) posées dans cet ordre,
que chaque chaîne de cellules (21) a des lignes de contact (17) qui présentent la même largeur que la chaîne de cellules et qui relient électriquement l'électrode de surface avant (3) d'une première cellule solaire (27) à l'électrode de surface arrière (11) d'une seconde cellule solaire (27), les première et seconde cellules solaires (27) étant comprises dans la chaîne de cellules (21) et voisines l'une de l'autre,
que les chaînes de cellules (21) aux deux extrémités, dans les trois chaînes de cellules (21), ou plus, présentent une largeur inférieure à celle des autres chaînes de cellules (21), et
que les chaînes de cellules (21) aux deux extrémités, dans les trois chaînes de cellules (21), ou plus, présentent une largeur de 5 mm ou plus et de 255 mm ou moins.

2. Module de cellules solaires à couche mince selon la revendication 1, étant précisé que les chaînes de cellules (21) aux deux extrémités dans les trois chaînes de cellules (21), ou plus, présentent une largeur qui représente 0,36 % ou plus et 18 % ou moins de la somme des largeurs de toutes les chaînes de cellules (21) comprises dans le module de cellules (1a).

3. Module de cellules solaires à couche mince (1) selon la revendication 1, étant précisé que le module de cellules (1a) comprend cinq chaînes de cellules (21) ou plus, et que la somme des largeurs des deux chaînes de cellules (21) les plus proches l'une de l'autre, y compris au moins l'une ou l'autre des extrémités des chaînes de cellules (21) dans les cinq chaînes de cellules (21) ou plus, est de 11 mm ou plus et de 255 mm ou moins, ou représente 0,71 % ou plus et 18 % ou moins de la somme des largeurs de toutes les chaînes de cellules (21) comprises dans le module de cellules (1a).

4. Module de cellules solaires à couche mince (1) selon la revendication 1, étant précisé que le module de cellules (1a) comprend sept chaînes de cellules (21) ou plus, et que la somme des largeurs des trois chaînes de cellules (21) les plus proches les unes des autres, y compris au moins l'une ou l'autre des extrémités des chaînes de cellules (21) dans les sept chaînes de cellules (21) ou plus, est de 17 mm ou plus et de 255 mm ou moins, ou représente 1,07 % ou plus et 18 % ou moins de la somme des largeurs de toutes les chaînes de cellules (21) comprises dans le module de cellules (1a).

5. Module de cellules solaires à couche mince (1) selon l'une quelconque des revendications 1 à 4, étant précisé que les chaînes de cellules (21) sont conçues pour avoir une puissance de sortie de 30 W ou moins dans des conditions telles que la source de lumière est une lampe à xénon, l'éclairement énergétique est de 100 mW/cm², la MA de 1,5 et la température de 25°C.

6. Module de cellules solaires à couche mince (1) selon l'une quelconque des revendications 1 à 5, étant précisé que chaque chaîne de cellules (21) comporte deux électrodes, l'une étant connectée électriquement à la première électrode commune (23) tandis que l'autre est connectée électriquement à la seconde électrode commune (23), que les chaînes de cellules (21) autres que les chaînes de cellules (21) situées aux deux extrémités dans les chaînes de cellules (21) satisfont à la condition que (P-Ps)/Sc est de 10,7(kW/cm²) ou moins, avec la puissance de sortie du module de cellules (1a) qui est P(W), la puissance de sortie des chaînes de cellules (21) qui est Ps(W), et la surface de la section transversale des lignes de contact (17) comprises dans les chaînes de cellules (21) qui est Sc(cm²), dans des conditions telles que la source de lumière est une lampe à xénon, l'éclairement énergétique est de 100 mW/cm², la MA de 1,5 et la température de 25°C.

7. Module de cellules solaires à couche mince (1) selon l'une quelconque des revendications 1 à 6, étant précisé que la chaîne de cellules (21) située au centre, dans les chaînes de cellules (21), présente une largeur supérieure à celle des autres chaînes de cellules (21).

8. Module de cellules solaires à couche mince (1) selon la revendication 7, étant précisé que la chaîne de cellules (21) située au centre présente une largeur de 670 mm ou moins ou une largeur qui représente 50 % ou moins de la somme des largeurs de toutes les chaînes de cellules (21) comprises dans le module de cellules (21).

9. Module de cellules solaires à couche mince (1) selon l'une quelconque des revendications 1 à 8, étant précisé que l'électrode de surface avant (3) se compose d'un film conducteur transparent composé d'un oxyde contenant du Sn, et que l'électrode de surface arrière (11) présente une structure multicouche d'un film conducteur transparent et d'un film en métal.

10. Module de cellules solaires à couche mince (1) selon l'une quelconque des revendications 1 à 9, étant précisé que le module de cellules (1) est conçu pour présenter une puissance de sortie de 90 W ou plus et de 385 W ou moins, dans des conditions telles que la source de lumière est une lampe à xénon, l'éclairement énergétique est de 100 mW/cm², la MA de 1,5 et la température de 25°C.
